# EUROPEAN PATENT APPLICATION

(11) **EP 2 453 516 A1**
(43) Date of publication of application: **16.05.2012**
(21) Application number: 11795824.9
(22) Date of filing: 10.06.2011
(51) Int. Cl.: H01M 14/00, H01L 31/04

(54) **PHOTOELECTRIC CONVERSION ELEMENT AND METHOD FOR PRODUCING SAME, AND ELECTRONIC DEVICE**

(30) Priority: 18.06.2010 JP 2010139179
(71) Applicant: Sony Corporation, Tokyo 108-0075 (JP)
(72) Inventor: TSUDA Ryohei, Tokyo 108-0075 (JP); ORIHASHI Masaki, Tokyo 108-0075 (JP)
(74) Representative: Berryman, Robert Jan
(86) International application number: PCT/JP2011/063863
(87) International publication number: WO 2011/158922

(57) **Abstract**

The present invention provides a photoelectric conversion element for use, for example, as a dye sensitized solar cell that has a wide range of choices of additives and moreover offers better characteristics than when 4-tert-butylpyridine is used as an additive.
In the photoelectric conversion element having a structure in which an electrolyte layer (7) is filled between a porous photoelectrode (3) formed above a transparent substrate (1) and a counter electrode (6), an additive having a pKₐ falling within the range of 6.04 ≤ pKₐ ≤ 7.3 is added to the electrolyte layer (7), and/or the additive having a pKₐ falling within the range of 6.04 ≤ pKₐ ≤ 7.3 is adsorbed to the surface of at least either the porous photoelectrode (3) or counter electrode (6) facing the electrolyte layer (7). A pyridine-based additive or an additive having a heterocycle is used as an additive. When the electrolyte layer (7) includes an electrolytic solution, a solvent having a molecular weight of 47.36 or more is used as the solvent of the electrolytic solution. In the dye sensitized photoelectric conversion element, a photosensitizing dye is bound to the surface of the porous photoelectrode (3).

## Description

### Technical Field

The present invention relates to a photoelectric conversion element, manufacturing method of the same and electronic equipment, and relates, for example, to a photoelectric conversion element suitable for use as a dye sensitized solar cell, a manufacturing method of the same and electronic equipment using the same.

### Background Art

A solar cell, i.e., a photoelectric conversion element adapted to convert sunlight into electric energy, uses sunlight as a source of energy, thus making its impact on the global environment extremely small and holding promise for even more widespread use.

Crystalline silicon-based solar cells using monocrystalline and polycrystalline silicons and amorphous silicon-based solar cells have been primarily used as solar cells.

On the other hand, a dye sensitized solar cell proposed by Gratzel et al. in 1991 offers high photoelectric conversion efficiency and moreover can be manufactured at low cost because this solar cell does not require any large-scale manufacturing system as do the conventional silicon-based solar cells, thus drawing attention (refer, for example, to Non-Patent Document 1).

In general, this dye sensitized solar cell has a porous photoelectrode and a counter electrode opposed to each other. The porous photoelectrode is made of titanium oxide to which a photosensitizing dye is bound. The counter electrode is made, for example, of platinum. An electrolyte layer made of an electrolytic solution is filled between the porous photoelectrode and counter electrode. An electrolyte containing redox species such as iodine or iodide ion dissolved in a solvent is often used as an electrolytic solution. An additive is commonly added to this electrolytic solution to prevent reverse electron transfer from the porous photoelectrode to the electrolyte layer. Four-tert-butylpyridine (TBP) is the best known additive.

### Prior Art Documents

### Non-Patent Documents

Non-Patent Document 1: Nature, 353, p.737 - 740, 1991
Non-Patent Document 2: Inorg. Chem. 1996, 35, 1168 - 1178
Non-Patent Document 3: J. Chem. Phys. 124, 184902(2006)

### Summary of Invention

However, the types of additives added to the electrolytic solution of the dye sensitized solar cell are limited, making the range of choices extremely small and resulting in low degree of freedom in designing the electrolytic solution.

In light of the foregoing, a problem to be solved by the present invention is to provide a photoelectric conversion element for use, for example, as a dye sensitized solar cell that has a wide range of choices of additives and moreover offers better characteristics than when 4-tert-butylpyridine is used as an additive.

Another problem to be solved by the present invention is to provide a manufacturing method of a photoelectric conversion element that can manufacture the excellent photoelectric conversion element as described above.

Still another problem to be solved by the present invention is to provide high performance electronic equipment using the excellent photoelectric conversion element as described above.

The present inventor et al. diligently made experimental and theoretical studies to solve the above problems. As a result, it was discovered that there are many additives that offer better characteristics than 4-tert-butylpyridine, an additive commonly added to the electrolyte layer. More specifically, we devised the present invention after having reached a conclusion that an additive having a pKₐ of 6.04 or more and 7.03 or less, i.e., a pKₐ falling within the range of 6.04 ≤ pKₐ ≤ 7.3, offers better characteristics than 4-tert-butylpyridine.

That is, in order to solve the above problems, the present invention is a photoelectric conversion element that has a structure in which an electrolyte layer is filled between a porous photoelectrode and counter electrode. An additive having a pKₐ falling within the range of 6.04 ≤ pKₐ ≤ 7.3 is added to the electrolyte layer, and/or the additive having a pKₐ falling within the range of 6.04 ≤ pKₐ ≤ 7.3 is adsorbed to the surface of at least either the porous photoelectrode or counter electrode facing the electrolyte layer.

Further, the present invention is a manufacturing method of a photoelectric conversion element that includes a step of adding an additive having a pKₐ falling within the range of 6.04 ≤ pKₐ ≤ 7.3 to an electrolyte layer filled between a porous photoelectrode and counter electrode, and/or a step of causing the additive having a pKₐ falling within the range of 6.04 ≤ pKₐ ≤ 7.3 to be adsorbed to the surface of at least either the porous photoelectrode or counter electrode facing the electrolyte layer.

Still further, the present invention is electronic equipment that includes a photoelectric conversion element having a structure in which an electrolyte layer is filled between a porous photoelectrode and counter electrode. An additive having a pKₐ falling within the range of 6.04 ≤ pKₐ ≤ 7.3 is added to the electrolyte layer, and/or the additive having a pKₐ falling within the range of 6.04 ≤ pKₐ ≤ 7.3 is adsorbed to the surface of at least either the porous photoelectrode or counter electrode facing the electrolyte layer.

In the present invention, basically any additive may be added to the electrolyte layer or adsorbed to the surface of at least either the porous photoelectrode or counter electrode so long as the additive has a pKₐ falling within the range of 6.04 ≤ pKₐ ≤ 7.3. Here, Kₐ is the dissociation equilibrium constant of a conjugate acid in water. This additive is typically a pyridine-based additive or an additive having a heterocycle. Among specific examples of pyridine-based additives are 2-aminopyridine(2-NH2-Py), 4-methoxypyridine(4-MeO-Py) and 4-ethylpyridine(4-Et-Py). However, the pyridine-based additives are not limited thereto. On the other hand, among specific examples of additives having a heterocycle are N-methylimidaaole(MTm), 2,4-lutidine(24-Lu), 2,5-lutidine(25-Lu), 2,6-lutidine(26-Lu), 3,4-lutidine(34-Lu) and 3,5-lutadine(35-Lu). However, the additives having a heterocycle are not limited thereto. The additive includes at least one selected from among a group made up, for example, of 2-aminopyridine, 4-methoxypyridine, 4-ethylpyridine, N-methylimidazole, 2,4-lutidine, 2,5-lutidine, 2,6-lutidine, 3,4-lutidine and 3,5-lutidine. It should be noted that compounds having, in their molecule, a pyridine or heterocyclic compound structure, both having a pKₐ falling within the range of 6.04≤pKₐ≤7.3, are expected to be as effective as the above additives having a pKₐ falling within the range of 6.04≤pKₐ≤7.3.

In order to cause an additive to be adsorbed to the surface of at least either the porous photoelectrode or counter electrode (interface between the porous photoelectrode or counter electrode and the electrolyte layer after filling the electrolyte layer), it is only necessary to bring the additive into contact with the surface of the porous photoelectrode or counter electrode before filling the electrolyte layer by using, for example, the additive itself, an organic solvent containing the additive or an electrolytic solution containing the additive. More specifically, it is only necessary, for example, to immerse the porous photoelectrode or counter electrode in an organic solvent containing the additive or spray an organic solvent containing the additive on the surface of the porous photoelectrode or counter electrode.

The electrolyte layer typically includes an electrolytic solution. However, the electrolyte layer may include an electrolytic solution quasi-solidified by adding nanostructures such as silica microparticles, clay or carbon nanotubes. Alternatively, the electrolyte layer may include a solid substance having a proper redox potential and capable of transporting holes.

When the electrolyte layer includes an electrolytic solution, the molecular weight of the solvent of the electrolytic solution is preferably 47.36 or more. Among such solvents are nitrile-based solvents such as 3-methoxypropionitrile (MPN), methoxyacetonitrile (MAN), acetonitrile (AN) and valeronitrile (VN), carbonate-based solvents such as ethylene carbonate and propylene carbonate, sulfone-based solvent such as sulfolane and lactone-based solvent such as γ-butyrolactone. Each of these may be used alone, or two or more may be used in combination as a mixture. However, the solvents of the electrolytic solution are not limited thereto.

The photoelectric conversion element is typically a dye sensitized photoelectric conversion element in which a photosensitizing dye is bound (or adsorbed) to the porous photoelectrode. In this case, the manufacturing method of a photoelectric conversion element typically includes a step of binding the photosensitizing dye to the porous photoelectrode. This porous photoelectrode includes fine particles made of a semiconductor. The semiconductor suitably includes titanium oxide (TiO₂), and, above all, TiO₂ in an anatase form.

An electrode including fine particles having a so-called core-shell structure may be used as the porous photoelectrode. In this case, a photosensitizing dye need not be bound. As this porous photoelectrode, an electrode including fine particles, each having a metallic core and a metal oxide shell wrapped around the core, is preferably used. Using the porous photoelectrode as described above keeps the electrolyte of the electrolyte layer out of contact with the core made of the metal of metal/metal oxide fine particles when an electrolyte layer is filled between this porous photoelectrode and counter electrode, thus preventing the dissolution of the porous photoelectrode by the electrolyte. This makes it possible to use, for example, gold (Au), silver (Ag) and copper (Cu) having large surface plasmon resonance effect, i.e., the metals that have been hitherto difficult to use as the core made of the metal of the metal/metal oxide fine particles, thus achieving sufficient surface plasmon resonance effect in photoelectric conversion. Further, an iodine-based electrolyte can be used as the electrolyte of the electrolyte layer. Platinum (Pt) and palladium (Pd) can also be used as the metal forming the core of each of the metal/metal oxide fine particles. As the metal oxide forming the shell of each of the metal/metal oxide fine particles, that which does not dissolve in the electrolyte used is used and selected as necessary. As such a metal oxide, at least one selected from a group consisting of titanium oxide (TiO₂), tin oxide (SnO₂), niobium oxide (Nb₂O₅) and zinc oxide (ZnO) is used. However, the metal oxides are not limited thereto. For example, metal oxides such as tungsten oxide (WO₃) and strontium titanate (SrTiO₃) may also be used. Although selected as appropriate, the size of the fine particles is preferably 1 to 500 nm. Further, although also selected as appropriate, the size of the fine particle cores is preferably 1 to 200 nm.

The photoelectric conversion element is most typically configured as a solar cell. However, the photoelectric conversion element may serve, for example, as a photosensor rather than a solar cell.

The electronic equipment may be basically any piece of electronic equipment and includes both portable and stationary types. Among specific examples are cell phones, mobile devices, robots, personal computers, car-mounted devices and a variety of home electric appliances. In this case, the photoelectric conversion element is, for example, a solar cell used as a power source of these pieces of electronic equipment.

Incidentally, a volatile organic solvent such as acetonitrile has been used as a solvent of the electrolytic solution of a dye sensitized solar cell. However, the exposure of the electrolytic solution to the atmosphere in the event of a fracture of a dye sensitized solar cell has led to the transpiration of the electrolytic solution, thus resulting in failures. In order to solve this problem, non-volatile molten salts called ionic liquids have found application in recent years as a solvent of the electrolytic solution in place of a volatile organic solvent (refer, for example, to Non-Patent Documents 2 and 3). As a result, improvement is seen in the problem of volatilization of the electrolytic solution. However, ionic liquids have significantly higher viscosity coefficients than conventionally used organic solvents. As a result, a dye sensitized solar cell using such an ionic liquid has poorer photoelectric conversion characteristic than the conventional dye sensitized solar cells. Therefore, a dye sensitized solar cell is sought after which can keep the volatilization of the electrolytic solution to a minimum and yet offers excellent photoelectric conversion characteristic. For this reason, the present inventor et al. diligently made studies to solve this problem. In the process of these studies, the present inventor et al. made attempts to dilute an ionic liquid with a volatile organic solvent while making search for remedies for the problem of deterioration of the photoelectric conversion characteristic caused by the use of an ionic liquid as a solvent of the electrolytic solution. The attempts were made under the projection that no remedial effect would be achieved. The results turned out to be what was expected. That is, if a solvent obtained by diluting the ionic liquid with a volatile organic solvent is used as the electrolytic solution, the viscosity coefficient of the electrolytic solution drops, thus providing improved photoelectric conversion characteristic. However, the problem of volatilization of the electrolytic solution remains unsolved. In order to carry out the above verification, however, we made further attempts to dilute the ionic liquid with a variety of organic solvents. As a result, we discovered that specific combinations of an ionic liquid and an organic solvent can effectively suppress the volatilization of the electrolytic solution without deteriorating the photoelectric conversion characteristic. This was a surprisingly unexpected result. Then, we went on with our experimental and theoretical studies based on this unexpectedly obtained knowledge and came to a conclusion that it would be effective to include, in the solvent of the electrolytic solution, an ionic liquid having electron pair accepting functional groups and an organic solvent having electron pair donating functional groups.

Here, the term "ionic liquid" described above includes not only those salts in a liquid form at 100°C but also other salts that form one or more phases and turn into a liquid form when a solvent is added. The ionic liquid may be basically any such liquid as long as it has electron pair accepting functional groups. The organic solvent may be basically any such solvent as long as it has electron pair donating functional groups. The ionic liquid typically contains a cation that has an electron pair accepting functional group. This ionic liquid suitably includes an organic cation that includes an aromatic amine cation having quaternary nitrogen atoms and that has hydrogen atoms in the aromatic ring, and an anion having a van der Waals volume of 76 Å³ or more (including not only organic anion but also inorganic anions such as AlCl₄⁻ and FeCl₄⁻). However, the ionic liquids are not limited thereto. The content of the ionic liquid in the solvent is selected as necessary. However, 15 or more weight percent to less than 100 weight percent of the ionic liquid is contained in the solvent that includes the ionic liquid and organic solvent. The electron pair donating functional group of the organic solvent is suitably an ether group or amino group, but is not limited thereto.

If the solvent of the electrolytic solution includes an ionic liquid having electron pair accepting functional groups and an organic solvent having electron pair donating functional groups as described above, the following advantageous effect can be achieved. That is, a hydrogen bond is formed between the electron pair accepting functional group of the ionic liquid and the electron pair donating functional group of the organic solvent in the solvent of the electrolytic solution. The ionic liquid molecule and organic solvent molecule bind together via this hydrogen bond, thus making it possible to suppress the volatilization of the electrolytic solution, and therefore of the electrolytic solution more than when the organic solvent is used alone. Further, because the solvent of the electrolytic solution contains the organic solvent in addition to the ionic liquid, it is possible to reduce the viscosity coefficient of the electrolytic solution more than when the ionic liquid is used alone as the solvent, thus preventing the deterioration of the photoelectric conversion characteristic.

In the present invention, an additive having a pKₐ falling within the range of 6.04 ≤ pKₐ ≤ 7.3 is added to the electrolyte layer, and/or the additive having a pKₐ falling within the range of 6.04 ≤ pKₐ ≤ 7.3 is adsorbed to the surface of at least either the porous photoelectrode or counter electrode. This provides a photoelectric conversion element that has a wide range of choices of additives used in the electrolyte layer and moreover offers better characteristics than when 4-tert-butylpyridine is used as an additive. Then, high performance electronic equipment, for example, can be implemented using this excellent photoelectric conversion element.

### Brief Description of Drawings

Fig. 1 is a sectional view illustrating a dye sensitized photoelectric conversion element according to a first embodiment of the present invention.
Fig. 2 is a schematic diagram for describing the operating principle of the dye sensitized photoelectric conversion element according to the first embodiment of the present invention.
Fig. 3 is a schematic diagram illustrating the structural formula of Z907.
Fig. 4 is a schematic diagram illustrating a measurement result of IPCE spectrum of the dye sensitized photoelectric conversion element in which the Z907 is bound alone to a porous photoelectrode.
Fig. 5 is a schematic diagram illustrating the structural formula of a dye A.
Fig. 6 is a schematic diagram illustrating a measurement result of IPCE spectrum of the dye sensitized photoelectric conversion element in which the dye A is bound alone to the porous photoelectrode.
Fig. 7 is a schematic diagram illustrating the relationship between pKₐ of various additives and the photoelectric conversion efficiency of the dye sensitized photoelectric conversion element in which these additives have been added to an electrolytic solution.
Fig. 8 is a schematic diagram illustrating the relationship between pKₐ of the various additives added to the electrolytic solution and the internal resistance of the dye sensitized photoelectric conversion element in which these additives have been added to the electrolytic solution.
Fig. 9 is a schematic diagram illustrating the dependence of the effects of the additives on the solvent species of the electrolytic solution.
Fig. 10 is a schematic diagram illustrating TG-DTA measurement results of various solvents.
Fig. 11 is a schematic diagram illustrating TG-DTA measurement results of various solvents.
Fig. 12 is a schematic diagram illustrating TG-DTA measurement results of various solvents.
Fig. 13 is a schematic diagram illustrating TG-DTA measurement results of various solvents.
Fig. 14 is a schematic diagram illustrating measurement results of the relationship between the content of EMImTCB in a mixture solvent of EMImTCB and triglyme and the percentage of decrease in evaporation rate.
Fig. 15 is a schematic diagram illustrating measurement results of the relationship between van der Waals volumes of anions of various ionic liquids and the percentage of decrease in evaporation rate.
Fig. 16 is a schematic diagram illustrating how a hydrogen bond is formed between an ionic liquid having electron pair accepting functional groups and an organic solvent having electron pair donating functional groups.
Fig. 17 is a schematic diagram illustrating how a plurality of hydrogen bonds are formed between an ionic liquid having an electron pair accepting functional group and an organic solvent having a plurality of electron pair donating functional groups.
Fig. 18 is a sectional view illustrating the dye sensitized photoelectric conversion element according to a third embodiment of the present invention.
Fig. 19 is a sectional view illustrating the configuration of metal/metal oxide fine particles of the porous photoelectrode in the dye sensitized photoelectric conversion element according to the third embodiment of the present invention.
Fig. 20 is a sectional view illustrating the photoelectric conversion element according to a fourth embodiment of the present invention.
Fig. 21 is a schematic diagram illustrating the structural formula of Z991.

### Modes for Carrying Out the Invention

A description will be given below of the modes for carrying out the present invention (hereinafter referred to as embodiments). It should be noted that the description will be given in the following order.
1. First embodiment (dye sensitized photoelectric conversion element and manufacturing method of the same)
2. Second embodiment (dye sensitized photoelectric conversion element and manufacturing method of the same)
3. Third embodiment (dye sensitized photoelectric conversion element and manufacturing method of the same)
4. Fourth embodiment (photoelectric conversion element and manufacturing method of the same)
5. Fifth embodiment (dye sensitized photoelectric conversion element and manufacturing method of the same)

### <1. First Embodiment>

### [Dye Sensitized Photoelectric Conversion Element]

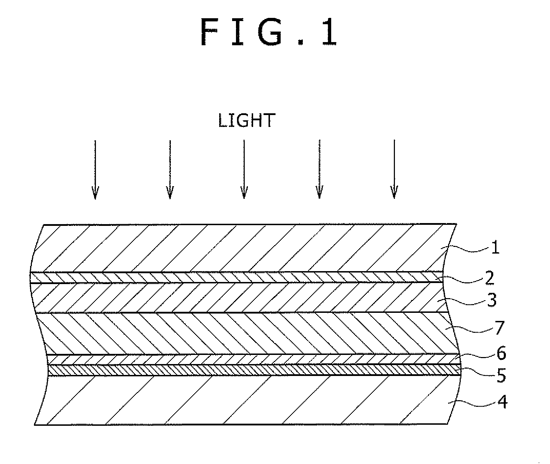

Fig. 1 is a sectional view of major parts showing a dye sensitized photoelectric conversion element according to a first embodiment.

As illustrated in Fig. 1, a transparent electrode 2 is provided on one of the main surfaces of a transparent substrate 1 in the dye sensitized photoelectric conversion element. A porous photoelectrode 3 is provided on the transparent electrode 2. One or a plurality of types of photosensitizing dyes (not shown) are bound to the porous photoelectrode 3. On the other hand, a conductive layer 5 is provided on one of the main surfaces of an opposed substrate 4. A counter electrode 6 is provided on the conductive layer 5. Then, an electrolyte layer 7 made of an electrolytic solution is filled between the porous photoelectrode 3 provided above the transparent substrate 1 and the counter electrode 6 provided above the opposed substrate 4. The outer peripheries of the transparent substrate 1 and opposed substrate 4 are sealed with a sealing agent (not shown).

A porous semiconductor layer, formed by sintering semiconductor fine particles, is typically used as the porous photoelectrode 3. The photosensitizing dye is adsorbed to the surfaces of the semiconductor fine particles. Among semiconductors that can be used as the material of the semiconductor fine particles are elementary semiconductors typified by silicon, compound semiconductors and semiconductors having a perovskite structure. These semiconductors should preferably be n-type semiconductors in which conduction band electrons serve as carriers to produce an anode current under photoexcitation. More specifically, semiconductors made of titanium oxide (TiO₂), zinc oxide (ZnO), tungsten oxide (WO₃), niobium oxide (Nb₂O₅), strontium titanate (SrTiO₃) and tin oxide (SnO₂) are, for example, used. Of these semiconductors, TiO₂ and, above all, TiO₂ in an anatase form, should preferably be used. It should be noted, however, that the types of semiconductors that can be used are not limited thereto, and that two or more different semiconductors can be mixed or conjugated for use as necessary. Further, the semiconductor fine particles may be in any form including a particle, tubular or bar form.

The size of the semiconductor particles is not specifically limited. However, the size of the primary particles should preferably be 1 to 200 nm, and it is particularly preferred that the size thereof should be 5 to 100 nm. Further, particles larger in size than the semiconductor fine particles may be mixed so as to scatter incident light for improved quantum yield. In this case, the average size of the additional particles to be mixed should preferably be 20 to 500 nm. However, the average size thereof is not limited thereto.

The porous photoelectrode 3 should preferably have a large net surface area including the surfaces of the fine particles facing the pores in the porous semiconductor layer made of the semiconductor fine particles so that as much of the photosensitizing dye as possible can be bound. For this reason, the net surface area with the porous photoelectrode 3 formed on the transparent electrode 2 should preferably be at least 10 times as large as the external surface area (projected area) of the porous photoelectrode 3, and more preferably be at least 100 times as large. Although there is no specific limit to this ratio, the ratio is usually 1000 times or so.

In general, the thicker the porous photoelectrode 3, and the more there are semiconductor fine particles contained per unit projected area, the larger the net surface area, and the larger the amount of the photosensitizing dye that can be held per unit projected area, and therefore the higher the light absorptivity. On the other hand, the thicker the porous photoelectrode 3, the greater the distance over which the electrons that have transferred from the photosensitizing dye to the porous photoelectrode 3 diffuse before reaching the transparent electrode 2, and therefore, the greater the loss of electrons as a result of charge recombination in the porous photoelectrode 3. Therefore, there is a suitable range of thickness for the porous photoelectrode 3. This range of thickness is generally 0.1 to 100 µm, and should more preferably be 1 to 50 µm, and particularly preferably be 3 to 30 µm.

Among the solutions used as the electrolytic solution forming the electrolyte layer 7 are those containing a redox couple. There are no specific limitations on the redox couple so long as the substance has a proper redox potential. More specifically, among redox couples used are combinations of iodine (I₂) and metallic or organic iodide salt and combinations of bromine (Br₂) and metallic or organic bromide salt. Among cations forming a metallic salt are lithium (Li⁺), sodium (Na⁺), potassium (K⁺), cesium (Cs⁺), magnesium (Mg²⁺) and calcium (Ca²⁺). On the other hand, among suitable cations forming organic salt are quaternary ammonium ions such as tetraalkylammonium ions, pyridinium ions and imidazolium ions. Each of these may be used alone, or two or more may be used in combination.

In addition to the above, combinations of oxidant and reductant of organometallic complexes made of transition metals such as cobalt, iron, copper, nickel and platinum, sulfur compounds such as sodium polysulfide and a combination of alkylthiol and alkyl disulfide, viologen dye and a combination of hydroquinone and quinone may be used as the electrolytic solution forming the electrolyte layer 7.

Of those listed above, electrolytes made of a combination of iodine (I₂) and a quaternary ammonium compound such as lithium iodide (LiI), sodium iodide (NaI) and imidazoliumiodide are preferred. The concentration of electrolyte salt relative to the solvent should preferably be 0.05 M to 10 M, and more preferably be 0.2 to 3 M. The concentration of iodine (I₂) or bromine (Br₂) should preferably be 0.0005 M to 1 M, and more preferably be 0.001 to 0.5 M.

In this case, an additive having a pKₐ falling within the range of 6.04 ≤ pKₐ ≤ 7.3 is added to the electrolytic solution forming the electrolyte layer 7. Such an additive is, for example, a pyridine-based additive or has a heterocycle. Among specific examples of pyridine-based additives are 2-NH2-Py, 4-MeO-Py and 4-Et-Py. Among specific examples of additives having a heterocycle are MIm, 24-Lu, 25-Lu, 26-Lu, 34-Lu and 35-Lu.

On the other hand, a solvent having a molecular weight of 47.36 or more is used as the solvent of the electrolytic solution forming the electrolyte layer 7. Such a solvent is, for example, 3-methoxypropionitrile (MPN), methoxyacetonitrile (MAN), and a mixture of acetonitrile (AN) and valeronitrile (VN).

The transparent substrate 1 is not specifically limited so long as the material and shape thereof allow for ready transmission of light, and various materials may be used as the substrate. However, a material having high transmittance to visible light is particularly preferred for use as the substrate. Further, a material is preferred that can superbly shut out moisture and gases from the outside from entering the dye sensitized photoelectric conversion element and that is highly solvent-resistant and weather-resistant. More specifically, among examples of the material used as the transparent substrate 1 are transparent and inorganic materials such as quartz and glass, and transparent plastics such as polyethylene terephthalate, polyethylene naphthalate, polycarbonate, polystyrene, polyethylene, polypropylene, polyphenylene sulfide, polyvinylidene fluoride, acetylcellulose, brominated phenoxy, aramids, polyimides, polystyrenes, polyalylates, polysulfones and polyolefins. The thickness of the transparent substrate 1 is not specifically limited and may be selected as appropriate in consideration of the light transmittance and the capability to block the photoelectric conversion element both on the inside and outside.

The smaller the sheet resistance, the better the transparent electrode 2 provided on the transparent substrate 1. More specifically, the sheet resistance is preferably 500 Ω/□ or less, and more preferably 100 Ω/□ or less. Well-known materials can be used as the material forming the transparent electrode 2 and is selected as necessary. More specifically, among the materials forming the transparent electrode 2 are indium-tin composite oxide (ITO), tin oxide doped with fluorine (IV)SnO₂(FTO), tin oxide (IV)SnO₂ and zinc oxide (II)ZnO, and indium-zinc composite oxide (IZO). It should be noted, however, that the material forming the transparent electrode 2 is not limited thereto, and two or more materials may be used in combination.

There are no specific limitations on the photosensitizing dye to be bound to the porous photoelectrode 3 so long as the dye has a sensitizing function, and an organometallic complex, organic dye, metal/semiconductor nanoparticles and so on may be used as the photosensitizing dye. However, the photosensitizing dye should preferably have an acid functional group that is adsorbed to the surface of the porous photoelectrode 3. In general, the photosensitizing dye should preferably have, for example, a carboxy group or phosphate group. Above all, the photosensitizing dye having a carboxy group is preferred. Among specific examples of the photosensitizing dye are xanthene-based dyes such as rhodamine B, rose bengal, eosine and erythrosine, cyanine-based dyes such as merocyanine, quinocyanine and cryptocyanine, basic dyes such as phenosafranine, capri blue, thiocin and methylene blue, porphyrin-based compounds such as chlorophyll, zinc porphyrin and magnesium porphyrin. Among other examples are azo dye, phthalocyanine compounds, coumarin-based compounds, pyridine complex compounds, anthraquinone-based dyes, polycyclic quinon-based dyes, triphenyl methane-based dyes, indoline-based dyes, perylene-based dyes, π-conjugated polymers such as polythiophene and dimer to 20 mer of their monomers and quantum dots such as CdS and CdSe. Of these, the dyes of one type of metallic complex selected from a group of Ru, Os, Ir, Pt, Co, Fe and Cu and whose ligand has a pyridine ring or imidazolinium ring are preferred for their high quantum yield. Particularly, the dye molecules having cis-bis(isothiocyanato)-N,N-bis(2,2'-dipyridyl-4,4'-dicarboxylic acid)-ruthenium(II) or tris(isothiocyanato)-ruthenium(II)-2,2' :6',2"-terpyridine-4,4' ,4"-tricarboxylic acid are preferred for their wide absorption wavelength range. It should be noted, however, that the photosensitizing dyes are not limited thereto. Although one of these is typically used as the photosensitizing dye, two or more photosensitizing dyes may be mixed for use. If two or more photosensitizing dyes are mixed for use, the photosensitizing dye suitably has two dyes, an inorganic complex dye having the property of causing MLCT (Metal to Ligand Charge Transfer) and an organic molecular dye held by the porous photoelectrode 3 and having the intramolecular CT (Charge Transfer) property. In this case, the inorganic complex dye and organic molecular dye are adsorbed to the porous photoelectrode 3 in conformations different from each other. The inorganic complex dye suitably has a carboxy group or phosphono group as a functional group bound to the porous photoelectrode 3. On the other hand, the organic molecular dye suitably has, in the same carbon, a carboxy group or phosphono group and a cyano group, amino group, thiol group or thione group as functional groups bound to the porous photoelectrode 3. The inorganic complex dye has, for example, a polypyridine complex, and the organic molecular dye, has, for example, electron donating groups and electron accepting groups and is an aromatic polycyclic conjugated molecule with the intramolecular CT property.

Although the manner in which the photosensitizing dye is adsorbed to the porous photoelectrode 3 is not specifically limited, the photosensitizing dye may be dissolved in a solvent such as alcohols, nitriles, nitromethane, halogenated hydrocarbon, ethers, dimethyl sulfoxide, amides, N-methylpyrrolidone, 1,3-dimethyl imidazolidinone, 3-methyl oxazolidinone, esters, carbonate esters, ketones, hydrocarbon and water, after which the porous photoelectrode 3 may be immersed in this solution or the solution containing the photosensitizing dye may be applied to the porous photoelectrode 3. Further, deoxycholic acid, for example, may be added to reduce the intermolecular association of the photosensitizing dye. An UV absorber may be used in combination as necessary.

After causing the photosensitizing dye to be adsorbed to the porous photoelectrode 3, the surface of the porous photoelectrode 3 may be treated with an amine to promote the removal of the excessively adsorbed photosensitizing dye. Among examples of the amine are 4-tert-butylpyridine and polyvinylpyridine. These may be used in an 'as-is' manner when in a liquid form. Alternatively, they may be dissolved in an organic solvent for use.

As the material of the counter electrode 6, any desired material may be used so long as it is a conductive substance. However, if a conductive layer is formed on the side facing the electrolyte layer 7 made of an insulating material, this conductive layer may also be used. An electrochemically stable material should preferably be used as the material of the counter electrode 6. More specifically, platinum, gold, carbon, conductive polymer and so on should preferably be used.

In order to improve the catalysis of the reduction reaction in the counter electrode 6, on the other hand, it is preferred that a microstructure should be formed on the surface of the counter electrode 6 in contact with the electrolyte layer 7 in such a manner as to provide a larger net surface area. For example, it is preferred that the counter electrode 6 should have a platinum black surface if made of platinum and have a porous carbon surface if made of carbon. Platinum black can be formed by anodization or chloroplatinic acid treatment of platinum. On the other hand, porous carbon can be formed, for example, by sintering carbon fine particles or firing an organic polymer.

The counter electrode 6 is formed on the conductive layer 5 that is formed on one of the main surfaces of the opposed substrate 4. However, the location where the counter electrode 6 is to be formed is not limited thereto. As the material of the opposed substrate 4, opaque glass, plastics, ceramics and metals may be used. In addition, transparent materials such as transparent glass and plastics may also be used. The same materials as used for the transparent electrode 2 may also be used for the conductive layer 5.

A material offering light resistance, insulating properties and moisture resistance should preferably be used as a sealing agent. Among specific examples of the sealing agent are epoxy resins, UV hardening resins, acrylic resins, polyisoprene resins, EVA (ethylene vinyl acetate), ionomer resins, ceramics and various types of hot melt film.

In order to fill the electrolytic solution, on the other hand, a filling port is required. The location of the filling port is not specifically limited so long as the port is not provided on the porous photoelectrode 3 or on the area of the counter electrode 6 opposed to the porous photoelectrode 3. Further, the manner in which the electrolytic solution is filled is not specifically limited. However, it is preferred that the electrolytic solution should be filled into the photoelectric conversion element under vacuum with its outer periphery sealed and its filling port left open. In this case, the electrolytic solution is readily filled by capillary action by dripping a few drops of the solution into the filling port. Further, the electrolytic solution may be dripped under vacuum or heat as necessary. After the electrolytic solution is completely filled, remove the solution remaining on the filling port and seal the filling port. The sealing method is not specifically limited either. However, sealing may be accomplished by attaching a glass plate or plastic substrate with a sealing agent if necessary. Still further, in addition to the above, sealing may be accomplished by dripping the electrolytic solution onto the substrate and attaching the substrate under vacuum as in the ODF (One Drop Filling) process used for liquid crystal panels. It is possible to apply heat or pressure as necessary so as to ensure that the electrolytic solution is fully impregnated into the porous photoelectrode 3 after the sealing.

### [Manufacturing Method of the Dye Sensitized Photoelectric Conversion Element]

A description will be given next of the manufacturing method of this dye sensitized photoelectric conversion element.

First, a transparent conductive layer is formed on one of the main surfaces of the transparent substrate 1, for example, by sputtering, thus forming the transparent electrode 2.

Next, the porous photoelectrode 3 is formed on the transparent electrode 2. Although the method of forming the porous photoelectrode 3 is not specifically limited, a wet film forming method is preferred in consideration of physical properties, convenience, manufacturing cost and other factors. Of the wet film forming methods, the one adapted to prepare a dispersion solution in a paste form by uniformly dispersing a semiconductor particle powder or sol in a solvent such as water and then coat or print the transparent electrode 2 of the transparent substrate 1 with the dispersion solution is preferred. The coating or printing method is not specifically limited, and a well-known method can be used. More specifically, dipping, spraying, wire bar coating, spin coating, roller coating, blade coating, gravure coating and so on may be used as the coating method. On the other hand, relief printing, offset printing, gravure printing, intaglio printing, rubber plate printing, screen printing and so on may be used as the printing method.

If TiO₂ in an anatase form is used as the material of the semiconductor particles, a commercially available product in a powder, sol or slurry form as this TiO₂ in an anatase form may be used. Alternatively, such TiO₂ of a given particle size may be formed by a well-known method such as by hydrolyzing titanium oxide alkoxide. If a commercially available powder product is used, secondary aggregation of the particles should preferably be resolved, and when a dispersion solution in a paste form is prepared, the particles should preferably be crushed using a mortar or ball mill. At this time, acetyl acetone, nitrous acid, surfactant, chelating agent or others may be added to the dispersion solution in a paste form to prevent the particles whose secondary aggregation has been resolved from aggregating again. Further, a variety of thickening agents such as polymers including polyethylene oxide and polyvinyl alcohol or cellulose-based thickening agents may be added to the dispersion solution in a paste form so as to increase the viscosity of the dispersion solution.

After coating or printing the transparent electrode 2 with the semiconductor fine particles, the porous photoelectrode 3 should preferably be fired to achieve electrical connection between the semiconductor fine particles and provide improved mechanical strength of the porous photoelectrode 3 and improved adhesion thereof to the transparent electrode 2. The range of firing temperature is not specifically limited. However, the higher the firing temperature, the higher the electrical resistance of the transparent electrode 2, possibly resulting in melting of the transparent electrode 2. Normally, therefore, the range from 40 to 700°C is preferred, and the range from 40 to 650°C is more preferred. On the other hand, there are no specific limitations on the firing time, and the firing time is normally from 10 minutes to 10 hours or so.

After the firing, the porous photoelectrode 3 may be dipped into an aqueous solution of titanium tetrachloride or titanium oxide ultrafine particle sol of 10 nm or less in diameter to increase the surface area of the semiconductor fine particles and provide improved necking between the semiconductor fine particles. If a plastic substrate is used as the transparent substrate 1 adapted to support the transparent electrode 2, it is possible to form the porous photoelectrode 3 on the transparent electrode 2 using a dispersion solution in a paste form containing a binding agent and laminate the porous photoelectrode 3 onto the transparent electrode 2 using a hot press.

Next, the photosensitizing dye is bound to the porous photoelectrode 3 by immersing the transparent substrate 1 having the porous photoelectrode 3 formed thereon in a solution in which the photosensitizing dye is dissolved in a given solvent.

On the other hand, the conductive layer 5 and counter electrode 6 are successively formed on the opposed substrate 4, for example, by sputtering.

Next, the transparent substrate 1 and opposed substrate 4 are arranged in such a manner that the porous photoelectrode 3 and counter electrode 6 are opposed to each other with a given spacing of 1 to 100 µm, and preferably 1, to 50 µm, therebetween. Then, a sealing agent (not shown) is formed on the outer peripheries of the transparent substrate 1 and opposed substrate 4 to produce a space in which the electrolyte layer 7 is to be sealed. An electrolytic solution, to which the above additive has been added, is, for example, filled into this space via the filling port (not shown) formed in advance in the transparent electrode 1, thus forming the electrolyte layer 7, after which the filling port is closed.

The intended dye sensitized photoelectric conversion element is manufactured as described above.

### [Operation of the Dye Sensitized Photoelectric Conversion Element]

A description will be given next of the operation of the dye sensitized photoelectric conversion element.

This dye sensitized photoelectric conversion element operates as a battery having the counter electrode 6 as a cathode and the transparent electrode 2 as an anode when struck with light. The operating principle is as described below. It should be noted that we assume here that FTO is used as the material of the transparent electrode 2 and TiO₂ as the material of the porous photoelectrode 3, and that redox species I⁻/I₃⁻ is used as a redox couple. However, the materials of the transparent electrode 2 and porous photoelectrode 3 and the redox couple are not limited thereto. We also assume that one type of photosensitizing dye is bound to the porous photoelectrode 3.

When the photosensitizing dye, bound to the porous photoelectrode 3, absorbs the photons that strike the porous photoelectrode 3 after having passed through the transparent substrate 1 and transparent electrode 2, the electrons in the photosensitizing dye are excited from a ground state (HOMO) to an excited state (LUMO). The electrons thus excited are drawn out into the conduction band of TiO₂ forming the porous photoelectrode 3 via the electrical coupling between the photosensitizing dye and porous photoelectrode 3, thus passing through the porous photoelectrode 3 and reaching the transparent electrode 2.

On the other hand, the photosensitizing dye that has lost its electrons receives electrons from the reductant such as I⁻ in the electrolyte layer 7, for example, as a result of the reaction shown below, thus producing an oxidant such as I₃⁻ (conjugate between I₂ and I⁻) in the electrolyte layer 7.

2I⁻ → I₂ + 2e⁻

I₂ + I⁻ → I₃⁻

The oxidant thus produced reaches the counter electrode 6 as a result of dispersion and receives electrons from the counter electrode 6 by the reverse reaction of the above reaction, thus being reduced back to the original reductant.

I₃⁻ → I₂ + I⁻

I₂ + 2e⁻ → 2I⁻

The electrons sent out from the transparent electrode 2 to external circuitry perform electrical work in the external circuitry and then return to the counter electrode 6. As described above, optical energy is converted into electrical energy without making any change to the photosensitizing dye or electrolyte layer 7.

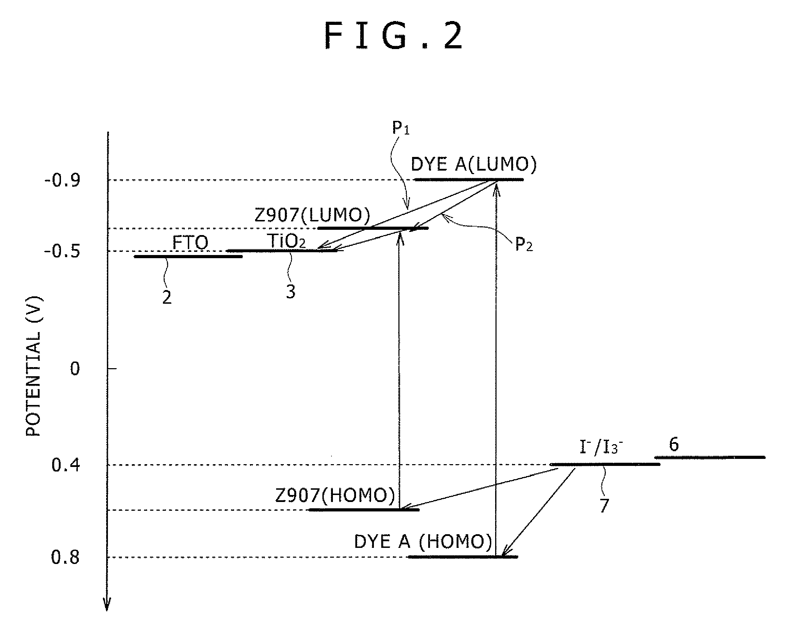

A description will be given next of the operation of the dye sensitized photoelectric conversion element in which two types of photosensitizing dyes are bound to the porous photoelectrode 3. We assume, as an example, here that Z907 and a dye A are bound to the porous photoelectrode 3. However, the two types of photosensitizing dyes are not limited thereto. The dye A is 2-Cyano-3-[4-[4-(2,2-diphenylethenyl)phenyl]-1,2,3,3a,4,8b-hexahydrocyclopent[b]indol-7-yl]-2-propenoic acid. Fig. 2 is an energy diagram for describing the operating principle of the dye sensitized photoelectric conversion element. This dye sensitized photoelectric conversion element operates as a battery having the counter electrode 6 as a cathode and the transparent electrode 2 as an anode when struck with light. The operating principle is as described below. It should be noted here that we assume that FTO is used as the material of the transparent electrode 2 and TiO₂ as the material of the porous photoelectrode 3, and that redox species I⁻/I₃⁻ is used as a redox couple. However, the materials of the transparent electrode 2 and porous photoelectrode 3 and the redox couple are not limited thereto.

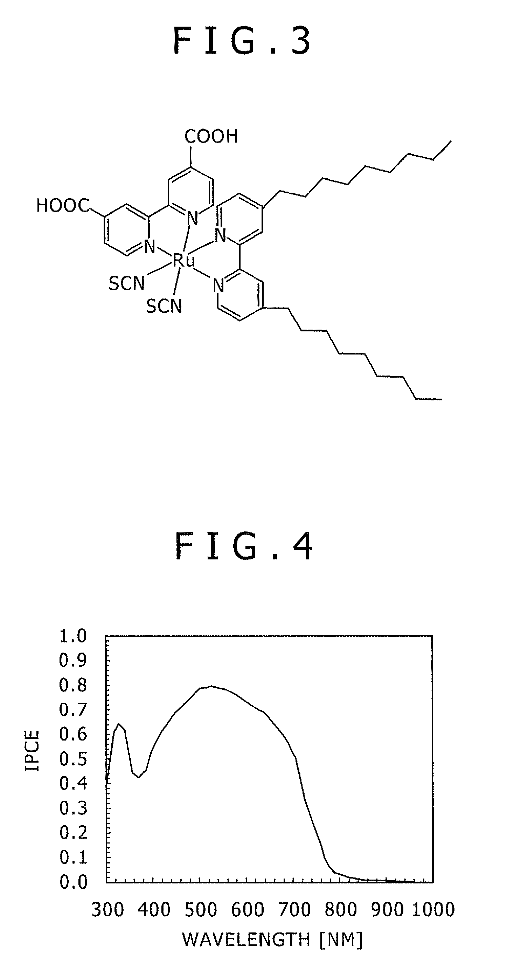

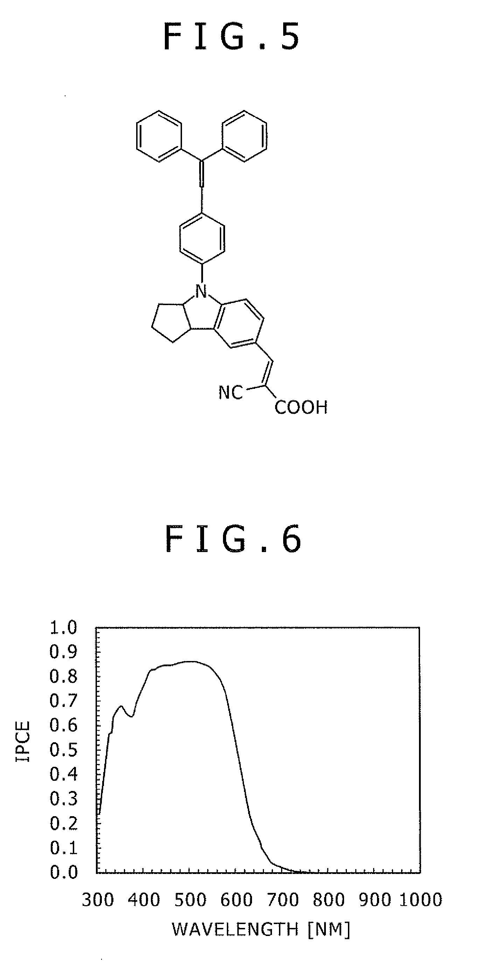

Further, Fig. 3 illustrates the structural formula of the Z907, and Fig. 4 a measurement result of IPCE (Incident Photon-to-current Conversion Efficiency) spectrum when the Z907 is adsorbed alone to the surface of the porous photoelectrode 3. Still further, Fig. 5 illustrates the structural formula of the dye A, and Fig. 6 a measurement result of IPCE spectrum when the dye A is adsorbed alone to the surface of the porous photoelectrode 3. As illustrated in Figs. 4 and 6, the Z907 can absorb light in a wide range of wavelengths. However, the Z907 has insufficient absorbance in the range of short wavelengths. In this range, the dye A having large absorbance in this range assists in light absorption. That is, the dye A serves as a photosensitizing dye having large absorbance in the range of short wavelengths.

As illustrated in Fig. 3, the Z907 has a carboxy group (-COOH) as a functional group to be strongly bound to the porous photoelectrode 3, and this carboxy group is bound to the porous photoelectrode 3. In contrast, as illustrated in Fig. 5, the dye A has a carboxy group (-COOH) as a functional group to be strongly bound to the porous photoelectrode 3 and a cyano group (-CN) as a functional group to be weakly bound to the porous photoelectrode 3. The carboxy and cyano groups are bound to the same carbon. Then, the carboxy and cyano groups of the dye A that are bound to the same carbon are bound to the porous photoelectrode 3. That is, the dye A is adsorbed to the porous photoelectrode 3 by the carboxy and cyano groups in a conformation different from that of the Z907 that is bound to the porous photoelectrode 3 only by the carboxy group. Here, if the plurality of functional groups of the dye A bound to the same carbon are all strongly bound to the porous photoelectrode 3, the conformation of the dye A adsorbed to the porous photoelectrode 3 has a low degree of freedom, making it difficult for the effect of presence of the plurality of functional groups bound to the same carbon to manifest itself. In contrast, the cyano group of the dye A that is weakly bound to the porous photoelectrode 3 plays an assisting role and moreover does not interfere with the binding of the strongly bound carboxy group to the porous photoelectrode 3. As a result, the effect of the binding of the carboxy and cyano groups to the same carbon effectively manifests itself in the dye A. That is, the dye A and Z907 can coexist without having any strong interaction with each other even if they are adjacent to each other on the surface of the porous photoelectrode 3, thus ensuring that their photoelectric conversion capabilities remain intact. On the other hand, the dye A effectively mediates between the Z907 molecules bound to the surface of the porous photoelectrode 3, suppressing the association of the Z907 molecules and preventing useless electron transfer therebetween. This prevents useless transfer of the excited electrons between the Z907 molecules that have absorbed light, thus allowing for effective extraction of the electrons into the porous photoelectrode 3 and contributing to improved photoelectric conversion efficiency of the Z907. Further, the excited electrons of the dye A that has absorbed light are extracted from the strongly bound carboxy group to the porous photoelectrode 3, thus allowing for effective charge transfer to the porous photoelectrode 3.

When the photosensitizing dyes, i.e., the Z907 and dye A, bound to the porous photoelectrode 3 absorb the photons that have passed through the transparent substrate 1, transparent electrode 2 and porous photoelectrode 3, the electrons in the Z907 and dye A are excited from a ground state (HOMO) to an excited state (LUMO). At this time, because the photosensitizing dyes are the Z907 and dye A, this dye sensitized photoelectric conversion element can absorb light in a wider range of wavelengths with higher light absorptivity than dye sensitized photoelectric conversion elements using a single photosensitizing dye.

The electrons in an excited state are drawn out into the conduction band of the porous photoelectrode 3 via the electrical coupling between the photosensitizing dyes, i.e., the Z907 and dye A, and the porous photoelectrode 3, thus passing through the porous photoelectrode 3 and reaching the transparent electrode 2. At this time, the minimum excitation energies of the Z907 and dye A, in other words, the HOMO-LUMO gaps, are sufficiently different. Moreover, the Z907 and dye A are bound to the porous photoelectrode 3 in conformations different from each other. This makes it unlikely that useless transfer of electrons may take place between the Z907 and dye A. Therefore, the photoelectric conversion capabilities of the Z907 and dye A manifest themselves without reducing their mutual quantum yields, thus contributing to a greater amount of current generated. Further, there are in this system two paths through which the electrons in the excited state of the dye A are drawn out into the conduction band of the porous photoelectrode 3. One of them is a direct path P₁ through which the electrons are directly drawn out from the excited state of the dye A into the conduction band of the porous photoelectrode 3. The other is an indirect path P₂ through which the electrons in the excited state of the dye A are drawn out into the excited state of the Z907 that is at a lower energy level first, and then drawn out from the excited state of the Z907 into the conduction band of the porous photoelectrode 3. The contribution of this indirect path P₂ provides improved photoelectric conversion efficiency in the system in which the dye A and Z907 coexist.

On the other hand, the dye A and Z907 that have lost their electrons receive electrons from the reductant such as I⁻ in the electrolyte layer 7, for example, as a result of the reaction shown below, thus producing an oxidant such as I₃⁻ (conjugate between I₂ and I⁻) in the electrolyte layer 7.

2I⁻ → I₂ + 2e⁻

I₂ + I⁻ → I₃⁻

The oxidant thus produced reaches the counter electrode 6 as a result of dispersion and receives electrons from the counter electrode 6 by the reverse reaction of the above reaction, thus being reduced back to the original reductant.

I₃⁻ → I₂ + I⁻

I₂ + 2e⁻ → 2I⁻

The electrons sent out from the transparent electrode 2 to external circuitry perform electrical work in the external circuitry and then return to the counter electrode 6. As described above, optical energy is converted into electrical energy without making any change to the photosensitizing dyes, i.e., the Z907 and dye A, or the electrolyte layer 7.

### <Working Example 1>

A dye sensitized photoelectric conversion element was manufactured in the following manner.

A TiO₂ dispersion solution in a paste form, i.e., the raw material used to form the porous photoelectrode 3, was prepared by referring to "The State of the Art of Dye Sensitized Solar Cells" editorially supervised by Hironori Arakawa, 2001, and published by CMC Publishing. That is, 125 ml of titanium isopropoxide was gradually dripped into a 750 ml aqueous solution of 0.1 M of nitric acid while being agitated at room temperature. After the dripping, the mixture was transferred to a thermostatic bath at 80°C, and the agitation was continued for eight hours, as a result of which a whitish and opaque sol solution was obtained. This sol solution was allowed to cool down to room temperature and then filtered with a glass filter, after which a solvent was added to increase the volume to 700 ml. The obtained sol solution was transferred to an auto clave and allowed to undergo a hydrothermal reaction for 12 hours at 220°C, after which the solution was subjected to an ultrasonic process followed by a dispersion process. Next, this solution was concentrated at 40°C using an evaporator and prepared so that the TiO₂ content was 20wt%. Polyethylene glycol equivalent to 20% of the mass of TiO₂ (500000 in molecular weight) and TiO₂ in an anatase form with a particle diameter of 200 nm and equivalent to 30% of the mass of TiO₂ was added to this concentrated sol solution, and the mixture was mixed evenly with a defoaming agitator to produce a TiO₂ dispersion liquid in a paste form with higher viscosity.

The above TiO₂ dispersion liquid in a paste form was applied onto the FTO layer, i.e., the transparent electrode 2, by blade coating, thus forming a 5 mm-by-5 mm and 200 µm-thick fine particle layer. Then, the temperature was maintained at 500°C for 30 minutes, thus sintering the TiO₂ fine particles on the FTO layer. An aqueous solution of 0.1 M titanium (IV) chloride TiCl₄ was dripped onto the sintered TiO₂ film, and then the film was maintained at room temperature for 15 hours, after which the film was cleaned and then fired again for 30 minutes at 500°C. Then, the TiO₂ sintered body was irradiated with UV light for 30 minutes with a UV irradiation system, thus oxidatively decomposing impurities such as organic substances contained in the TiO₂ sintered body by photocatalysis and removing these impurities. Then, a process adapted to improve the activity of the TiO₂ sintered body was performed, as a result of which the porous photoelectrode 3 was obtained.

A photosensitizing dye solution was prepared by dissolving, as a photosensitizing dye, 23.8 mg of fully purified Z907 in a 50 ml mixture solvent of acetonitrile and butanol mixed at a 1:1 volume ratio.

It should be noted that if the Z907 and dye A are used as photosensitizing dyes, a photosensitizing dye solution is prepared by dissolving, as photosensitizing dyes, 23.8 mg of fully purified Z907 and 2.5 mg of the dye A in a 50 ml mixture solvent of acetonitrile and butanol mixed at a 1:1 volume ratio.

Next, the porous photoelectrode 3 was immersed in this photosensitizing dye solution for 24 hours at room temperature, thus allowing the photosensitizing dye to be held on the TiO₂ fine particle surfaces. Next, the porous photoelectrode 3 was cleaned successively using an acetonitrile solution of 4-tert-butylpyridine and acetonitrile, after which the solvent was evaporated and the porous photoelectrode 3 dried at a dark location.

The counter electrode 6 was formed by stacking, by sputtering, a 50 nm-thick chromium layer and a 100 nm-thick platinum layer on the FTO layer in which a 0.5 mm filling port had been formed in advance, and then coating the platinum layer with an aqueous isopropyl alcohol (2-propanol) solution of hydrogen chloroplatinate by spraying, followed by heating at 385°C for 15 minutes.

Next, the transparent substrate 1 and opposed substrate 4 were arranged in such a manner that the porous photoelectrode 3 and counter electrode 6 were opposed to each other. The outer peripheries thereof were sealed with a 30 µm-thick ionomer resin film and acryl-based UV-hardening resin.

On the other hand, an electrolytic solution was prepared by dissolving 1.0 g of 1-propyl-3-methylimidazolium iodide, 0.10 g of iodine I₂ and 0.054 g of 2-NH2-Py as an additive in 2.0 g of 3-methoxypropionitrile (MPN).

It should be noted that if the Z907 and dye A are used as photosensitizing dyes, an electrolytic solution is prepared, for example, by dissolving 0.030 g of sodium iodide NaI, 1.0 g of 1-propyl-2,3-dimethylimidazolium iodide, 0.10 g of iodine I₂ and 0.054 g of 2-NH2-Py as an additive in 2.0 g of 3-methoxypropionitrile (MPN).

This electrolytic solution was filled from the filling port of the dye sensitized photoelectric conversion element prepared in advance using a feed pump, and then the photoelectric conversion element was placed into a vacuum, thus removing air bubbles trapped therein. The electrolyte layer 7 is formed as described above. Next, the filling port was sealed with an ionomer resin film, acrylic resin and glass substrate, thus completing the dye sensitized photoelectric conversion element.

### <Working Example 2>

An electrolytic solution was prepared by using 4-MeO-Py as an additive. A dye sensitized photoelectric conversion element was manufactured in the same manner as in working example 1 in all other respects.

### <Working Example 3>

An electrolytic solution was prepared by using 4-Et-Py as an additive. A dye sensitized photoelectric conversion element was manufactured in the same manner as in working example 1 in all other respects.

### <Working Example 4>

An electrolytic solution was prepared by using MIm as an additive. A dye sensitized photoelectric conversion element was manufactured in the same manner as in working example 1 in all other respects.

### <Working Example 5>

An electrolytic solution was prepared by using 24-Lu as an additive. A dye sensitized photoelectric conversion element was manufactured in the same manner as in working example 1 in all other respects.

### <Working Example 6>

An electrolytic solution was prepared by using 25-Lu as an additive. A dye sensitized photoelectric conversion element was manufactured in the same manner as in working example 1 in all other respects.

### <Working Example .7>

An electrolytic solution was prepared by using 26-Lu as an additive. A dye sensitized photoelectric conversion element was manufactured in the same manner as in working example 1 in all other respects.

### <Working Example 8>

An electrolytic solution was prepared by using 34-Lu as an additive. A dye sensitized photoelectric conversion element was manufactured in the same manner as in working example 1 in all other respects.

### <Working Example 9>

An electrolytic solution was prepared by using 35-Lu as an additive. A dye sensitized photoelectric conversion element was manufactured in the same manner as in working example 1 in all other respects.

### <Comparative Example 1>

An electrolytic solution was prepared without any additive. A dye sensitized photoelectric conversion element was manufactured in the same manner as in working example 1 in all other respects.

### <Comparative Example 2>

An electrolytic solution was prepared by using TBP as an additive. A dye sensitized photoelectric conversion element was manufactured in the same manner as in working example 1 in all other respects.

### <Comparative Example 3>

An electrolytic solution was prepared by using 4-pic as an additive. A dye sensitized photoelectric conversion element was manufactured in the same manner as in working example 1 in all other respects.

### <Comparative Example 4>

An electrolytic solution was prepared by using 4-COOMe-Py as an additive. A dye sensitized photoelectric conversion element was manufactured in the same manner as in working example 1 in all other respects.

### <Comparative Example 5>

An electrolytic solution was prepared by using 4-CN-Py as an additive. A dye sensitized photoelectric conversion element was manufactured in the same manner as in working example 1 in all other respects.

### <Comparative Example 6>

An electrolytic solution was prepared by using 4-NH2-Py as an additive. A dye sensitized photoelectric conversion element was manufactured in the same manner as in working example 1 in all other respects.

### <Comparative Example 7>

An electrolytic solution was prepared by using 4-MeNH-Py as an additive. A dye sensitized photoelectric conversion element was manufactured in the same manner as in working example 1 in all other respects.

### <Comparative Example 8>

An electrolytic solution was prepared by using 3-MeO-Py as an additive. A dye sensitized photoelectric conversion element was manufactured in the same manner as in working example 1 in all other respects.

### <Comparative Example 9>

An electrolytic solution was prepared by using 2-MeO-Py as an additive. A dye sensitized photoelectric conversion element was manufactured in the same manner as in working example 1 in all other respects.

### <Comparative Example 10>

An electrolytic solution was prepared by using 3-COOMe-Py as an additive. A dye sensitized photoelectric conversion element was manufactured in the same manner as in working example 1 in all other respects.

### <Comparative Example 11>

An electrolytic solution was prepared by using Py as an additive. A dye sensitized photoelectric conversion element was manufactured in the same manner as in working example 1 in all other respects.

### <Comparative Example 12>

An electrolytic solution was prepared by using 3-Br-Py as an additive. A dye sensitized photoelectric conversion element was manufactured in the same manner as in working example 1 in all other respects.

### <Comparative Example 13>

An electrolytic solution was prepared by using NMB as an additive. A dye sensitized photoelectric conversion element was manufactured in the same manner as in working example 1 in all other respects.

### <Comparative Example 14>

An electrolytic solution was prepared by using pyrazine as an additive. A dye sensitized photoelectric conversion element was manufactured in the same manner as in working example 1 in all other respects.

### <Comparative Example 15>

An electrolytic solution was prepared by using thiazole as an additive. A dye sensitized photoelectric conversion element was manufactured in the same manner as in working example 1 in all other respects.

### <Comparative Example 16>

An electrolytic solution was prepared by using Me-pyrazole as an additive. A dye sensitized photoelectric conversion element was manufactured in the same manner as in working example 1 in all other respects.

### <Comparative Example 17>

An electrolytic solution was prepared by using quinoline as an additive. A dye sensitized photoelectric conversion element was manufactured in the same manner as in working example 1 in all other respects.

### <Comparative Example 18>

An electrolytic solution was prepared by using isoquinoline as an additive. A dye sensitized photoelectric conversion element was manufactured in the same manner as in working example 1 in all other respects.

### <Comparative Example 19>

An electrolytic solution was prepared by using bpy as an additive. A dye sensitized photoelectric conversion element was manufactured in the same manner as in working example 1 in all other respects.

### <Comparative Example 20>

An electrolytic solution was prepared by using pyridazine as an additive. A dye sensitized photoelectric conversion element was manufactured in the same manner as in working example 1 in all other respects.

### <Comparative Example 21>

An electrolytic solution was prepared by using pyrimidine as an additive. A dye sensitized photoelectric conversion element was manufactured in the same manner as in working example 1 in all other respects.

### <Comparative Example 22>

An electrolytic solution was prepared by using acridine as an additive. A dye sensitized photoelectric conversion element was manufactured in the same manner as in working example 1 in all other respects.

### <Comparative Example 23>

An electrolytic solution was prepared by using 56-benzoquinoline as an additive. A dye sensitized photoelectric conversion element was manufactured in the same manner as in working example 1 in all other respects.

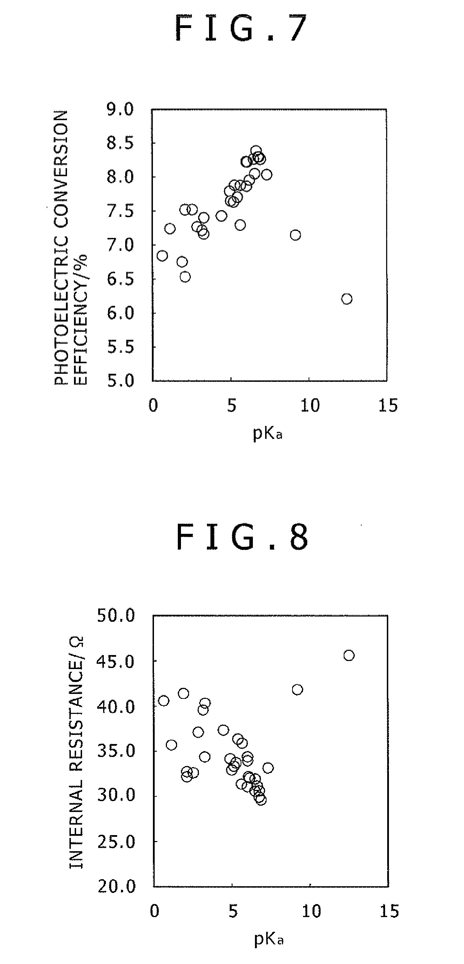

Table 1 illustrates the pKₐ (water), photoelectric conversion efficiencies (Eff.) and internal resistances (Rs) in working examples 1 to 3, each using a pyridine-based additive, and comparative examples 1 to 12. Table 2 illustrates the pKₐ (water), photoelectric conversion efficiencies (Eff.) and internal resistances (Rs) in working examples 4 to 9, each using an additive having a heterocycle, and comparative examples 13 to 23. It is clear from Tables 1 and 2 that each of working examples 1 to 9, all using an additive having a pKₐ falling within the range of 6.04 ≤ pKₐ ≤ 7.3, offers an equivalent or higher photoelectric conversion efficiency (Eff.) and a lower internal resistance (Rs) than comparative example 2 using 4-tert-butylpyridine. Fig. 7 plots the photoelectric conversion efficiencies (Eff.) relative to pKₐ in working examples 1 to 9 and comparative examples 1 to 23. On the other hand, Fig. 8 plots the internal resistances (Rs) relative to pKₐ in working examples 1 to 9 and comparative examples 1 to 23.

**(Table 1)**

| | Additive | pKₐ (water) | Eff [%] | Rs[ Ω] |
|---|---|---|---|---|
| Working Example 1 | 2-NH2-Py | 6.86 | 8.3 | 29.5 |
| Working Example 2 | 4-MeO-py | 6.62 | 8.4 | 31.0 |
| Working Example 3 | 4-Et-Py | 6.04 | 8.2 | 32.1 |
| Comparative Example 1 | No additive | | 7.1 | 35.5 |
| Comparative Example 2 | TBP | 5.99 | 7.9 | 33.8 |
| Comparative Example 3 | 4-pic | 6.03 | 7.9 | 34.3 |
| Comparative Example 4 | 3-COOMe-Py | 3.13 | 7.2 | 39.5 |
| Comparative Example 5 | 4-CN-Py | 1.9 | 6.7 | 41.3 |
| Comparative Example 6 | 4-NH2-Py | 9.17 | 7.1 | 41.7 |
| Comparative Example 7 | 4-MeNH-Py | 12.5 | 6.2 | 45.6 |
| Comparative Example 8 | 3-MeO-Py | 4.88 | 7.8 | 34.0 |
| Comparative Example 9 | 2-MeO-Py | 3.28 | 7.4 | 34.3 |
| Comparative Example 10 | 3-COOMe-Py | 3.13 | 7.2 | 39.5 |
| Comparative Example 11 | Py | 5.23 | 7.9 | 33.6 |
| Comparative Example 12 | 3-Br-Py | 2.84 | 7.3 | 36.9 |

**(Table 2)**

| | Additive | pKₐ(water) | Eff[%] | Rs[ Ω] |
|---|---|---|---|---|
| Working Example 4 | Mlm | 7.3 | 8.0 | 33.0 |
| Working Example 5 | 24-Lu | 6.72 | 8.3 | 29.9 |
| Working Example 6 | 25-Lu | 6.47 | 8.3 | 30.5 |
| Working Example 7 | 26-Lu | 6.77 | 8.3 | 30.6 |
| Working Example 8 | 34-Lu | 6.52 | 8.0 | 31.9 |
| Working Example 9 | 35-Lu | 6.14 | 7.9 | 32.0 |
| Comparative Example 13 | NMB | 5.6 | 7.9 | 35.8 |
| Comparative Example 14 | pyrazine | 0.6 | 6.8 | 40.4 |
| Comparative Example 15 | thiazole | 2.5 | 7.5 | 32.5 |
| Comparative Example 16 | Me-pyrazole | 2.1 | 7.5 | 32.7 |
| Comparative Example 17 | quinoline | 4.97 | 7.6 | 32.9 |
| Comparative Example 18 | isoquinoline | 5.38 | 7.7 | 36.1 |
| Comparative Example 19 | bpy | 4.42 | 7.4 | 37.2 |
| Comparative Example 20 | pyridazine | 2.1 | 6.5 | 32.0 |
| Comparative Example 21 | pyrimidine | 1.1 | 7.2 | 35.5 |
| Comparative Example 22 | acridine | 5.6 | 7.3 | 31.3 |
| Comparative Example 23 | 56-benzoquinoline | 5.15 | 7.6 | 33.3 |

A description will be given next of the dependence of the effects of the additives added to the electrolytic solution on the solvent species of the electrolytic solution.

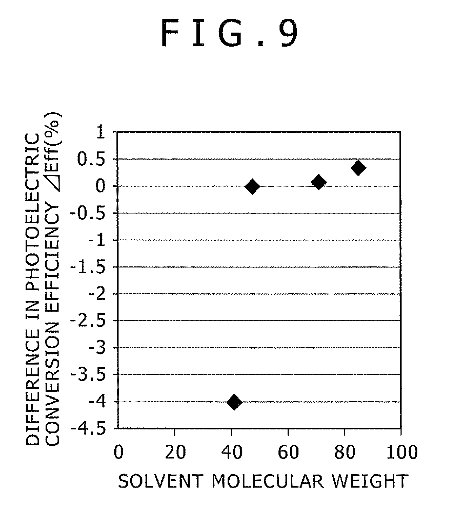

The effects of the additives were verified for each solvent having a different molecular weight. Here, 4-tert-butylpyridine (TBP) and 4-Et-Py (4-ethylpyridine) having relatively close pKₐ values were compared. The evaluation is as follows. The photoelectric conversion efficiency (Eff (4-Et-Py)) of the photoelectric conversion element using 4-Et-Py as an additive of the electrolytic solution and the photoelectric conversion efficiency (Eff (TBP)) of the photoelectric conversion element using TBP as an additive are measured for each solvent. Then, the difference between the two photoelectric conversion efficiencies ΔEff = Eff(4-Et-Py) - Eff(TBP) is used as an indicator. Four different solvents, namely, acetonitrile (AN), a mixture of acetonitrile (AN) and valeronitrile (VN), methoxyacetonitrile (MAN) and 3-methoxypropionitrile (MPN), were used. Table 3 illustrates the molecular weight, Eff(4-Et-Py), Eff(TBP) and ΔEff of each of the solvents. It should be noted, however, that the values reported in Solar Energy Materials & Solar Cells, 2003, 80, 167 were referred to as the Eff(4-Et-Py), Eff(TBP) and ΔEff values of acetonitrile (AN). Fig. 9 plots the difference between the photoelectric conversion efficiencies ΔEff relative to the molecular weight of each of the solvents.

**(Table 3)**

| Solvent | Molecular Weight | Eff(4-Et-Py) | Eff(TBP) | ΔEff |
|---|---|---|---|---|
| AN | 41.05 | 3.4 | 7.4 | -4 |
| AN/VN | 47.36 | 8.72 | 8.69 | 0.03 |
| MAN | 71.08 | 8.05 | 7.96 | 0.09 |
| MPN | 85.1 | 8.22 | 7.86 | 0.36 |

It is clear from Table 3 and Fig. 9 that the range of molecular weight in which ΔEff>0, in other words, Eff(4-Et-Py) is greater than Eff(TBP), is 47.36 or more. It should be noted, however, that the molecular weight of 47.36 is an apparent molecular weight calculated using the volume fraction of a mixture of acetonitrile (AN) and valeronitrile (VN).

From the above, it is clearly safe to say that it is effective to use an additive having a pKₐ falling within the range of 6.04 ≤ pKₐ ≤ 7.3 as an additive of the electrolytic solution for a solvent having a molecular weight of 47.36 or greater.

As described above, an additive having a pKₐ falling within the range of 6.04 ≤ pKₐ ≤ 7.3 is used as an additive of the electrolytic solution forming the electrolyte layer 7 in the first embodiment. This contributes to equivalent or greater photoelectric conversion efficiency and equivalent or smaller internal resistance than those available with conventional dye sensitized photoelectric conversion elements using 4-tert-butylpyridine as an additive of the electrolytic solution, thus providing a photoelectric conversion element offering excellent photoelectric conversion characteristic. Further, a variety of additives have a pKₐ falling within the range of 6.04 ≤ pKₐ ≤ 7.3, thus offering an extremely wide range of choices of additives.

### <2. Second Embodiment>

### [Dye Sensitized Photoelectric Conversion Element]

This dye sensitized photoelectric conversion element differs from the counterpart according to the first embodiment in that at least an ionic liquid having electron pair accepting functional groups and an organic solvent having electron pair donating functional groups are used as solvents of the electrolytic solution forming the electrolyte layer 7.

A cation forming the ionic liquid typically has an electron accepting functional group. The cation of the ionic liquid suitably includes an organic cation that includes an aromatic amine cation having quaternary nitrogen atoms and that has hydrogen atoms in the aromatic ring. Among examples of such an organic cation are imidazolium cation, pyridium cation, thiazolium cation and pyrazolium cation. However, the organic cation is not limited thereto. As the anion of the ionic liquid, an anion having a van der Waals volume of 76 Å³ or more is suitably used, and that having a van der Waals volume of 100 Å³ or more is more suitably used.

Among specific examples of the ionic liquid having electron accepting functional groups are as follows.
- EMImTCB: 1-ethyl-3-methylimidazolium tetracyanoborate
- EMImTFSI: 1-ethyl-3-methylimidazolium bis (trifluoromethanesulfone) imide
- EMImFAP: 1-ethyl-3-methylimidazolium tris (pentafluoroethyl) trifluorophosphate
- EMImBF₄: 1-ethyl-3-methylimidazolium tetrafluoroborate

Among specific examples of organic solvents having electron pair donating functional groups are as follows.
MPN: 3-methoxypropionitrile (MPN)
GBL: γ-butyrolactone
DMF: N,N-dimethylformamide
diglyme: diethylene glycol dimethyl ether
triglyme: triethylene glycol dimethylether
tetraglyme: tetraethylene glycol dimethyl ether
PhOAN: phenoxy acetonitrile
PC: propylene carbonate
aniline: aniline
DMniline: N,N-dimethylaniline
NBB: N-butylbenzimidazole
TBP: tert-butylpyridine

Specific examples of organic solvents having a tertiary nitrogen atom can be classified into five types as shown below.
(1) Methylamine, dimethylamine, trimethylamine, ethylamine, diethylamine, ethylmethylamine, n-propylamine, iso-propyl, dipropylamine, n-butylamine, sec-butylamine and tert-butylamine
(2) Ethylenediamine
(3) Aniline and N,N-dimethylaniline
(4) Formamide, N-methylformamide, N,N-dimethylformamide, acetoamide, N-methylacetoamide and N,N-dimethylacetoamide
(5) N-methylpyrrolidone

The organic solvents classified into types (1) to (4) are organic molecules with a molecular weight of 1000 or less having the following molecular framework represented by a general formula.

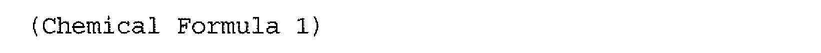

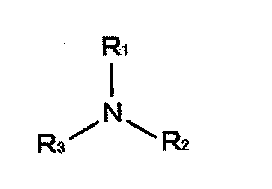

It should be noted, however, that R₁, R₂ and R₃ in the formula are each one of substitution groups selected from among H, CnHm(n = 1 to 20, m = 3 to 41), phenyl group, aldehyde group and acetyl group.

### [Manufacturing Method of the Dye Sensitized Photoelectric Conversion Element]

The manufacturing method of this dye sensitized photoelectric conversion element is identical to the counterpart according to the first embodiment except that at least an ionic liquid having electron pair accepting functional groups and an organic solvent having electron pair donating functional groups are used as solvents of the electrolytic solution forming the electrolyte layer 7.

### <Working Example 10>

A dye sensitized photoelectric conversion element was manufactured in the following manner.

The porous photoelectrode 3 holding a photosensitizing dye was formed on the transparent electrode 1, and the counter electrode 6 was formed on the opposed electrode 4 in the same manner as in working example 1.

Next, the transparent substrate. 1 and opposed substrate 4 were arranged in such a manner that the porous photoelectrode 3 and counter electrode 6 were opposed to each other. The outer peripheries thereof were sealed with a 30 µm-thick ionomer resin film and acryl-based UV-hardening resin.

On the other hand, an electrolytic solution was prepared by dissolving 1.0 g of 1-propyl-3-methylimidazolium iodide, 0.10 g of iodine I₂ and 0.054 g of 2-NH2-Py as an additive in 2.0 g of a mixture solvent of EMImTCB and diglyme mixed at a 1:1 weight ratio.

It should be noted that if the Z907 and dye A are used as photosensitizing dyes, an electrolytic solution is prepared, for example, by dissolving 0.030 g of sodium iodide NaI, 1.0 g of 1- propyl-2,3-dimethylimidazolium iodide, 0.10 g of iodine I₂ and 0.054 g of 2-NH2-Py as an additive in 2.0 g of a mixture solvent of EMImTCB and diglyme mixed at a 1:1 weight ratio.

This electrolytic solution was filled from the filling port of the dye sensitized photoelectric conversion element prepared in advance using a feed pump, and then the photoelectric conversion element was placed into a vacuum, thus removing air bubbles trapped therein. The electrolyte layer 7 is formed as described above. Next, the filling port was sealed with an ionomer resin film, acrylic resin and glass substrate, thus completing the dye sensitized photoelectric conversion element.

### <Working Example 11>

An electrolytic solution was prepared by using a mixture solvent of EMImTCB and triglyme mixed at a 1:1 weight ratio as a solvent. A dye sensitized photoelectric conversion element was manufactured in the same manner as in working example 10 in all other respects.

### <Working Example 12>

An electrolytic solution was prepared by using a mixture solvent of EMImTCB and tetraglyme mixed at a 1:1 weight ratio as a solvent. A dye sensitized photoelectric conversion element was manufactured in the same manner as in working example 10 in all other respects.

### <Working Example 13>

An electrolytic solution was prepared by using a mixture solvent of EMImTCB and MPN mixed at a 1:1 weight ratio as a solvent. A dye sensitized photoelectric conversion element was manufactured in the same manner as in working example 10 in all other respects.

### <Working Example 14>

An electrolytic solution was prepared by using a mixture solvent of EMImTCB and PhOAN mixed at a 1:1 weight ratio as a solvent. A dye sensitized photoelectric conversion element was manufactured in the same manner as in working example 10 in all other respects.

### <Working Example 15>

An electrolytic solution was prepared by using a mixture solvent of EMImTCB and GBL mixed at a 1:1 weight ratio as a solvent. A dye sensitized photoelectric conversion element was manufactured in the same manner as in working example 10 in all other respects.

### <Working Example 16>

An electrolytic solution was prepared by using a mixture solvent of EMImTCB and PC mixed at a 1:1 weight ratio as a solvent. A dye sensitized photoelectric conversion element was manufactured in the same manner as in working example 10 in all other respects.

### <Working Example 17>

An electrolytic solution was prepared by using a mixture solvent of EMImTCB and aniline mixed at a 1:1 weight ratio as a solvent. A dye sensitized photoelectric conversion element was manufactured in the same manner as in working example 10 in all other respects.

### <Working Example 18>

An electrolytic solution was prepared by using a mixture solvent of EMImTCB and DMF mixed at a 1:1 weight ratio as a solvent. A dye sensitized photoelectric conversion element was manufactured in the same manner as in working example 10 in all other respects.

### <Working Example 19>

An electrolytic solution was prepared by using a mixture solvent of EMImTCB and DManiline mixed at a 1:1 weight ratio as a solvent. A dye sensitized photoelectric conversion element was manufactured in the same manner as in working example 10 in all other respects.

### <Working Example 20>

An electrolytic solution was prepared by using a mixture solvent of EMImTCB and NBB mixed at a 1:1 weight ratio as a solvent. A dye sensitized photoelectric conversion element was manufactured in the same manner as in working example 10 in all other respects.

### <Working Example 21>

An electrolytic solution was prepared by using a mixture solvent of EMImTCB and TBP mixed at a 1:1 weight ratio as a solvent. A dye sensitized photoelectric conversion element was manufactured in the same manner as in working example 10 in all other respects.

### <Working Example 22>

An electrolytic solution was prepared by using a mixture solvent of EMImTFSI and triglyme mixed at a 1:1 weight ratio as a solvent. A dye sensitized photoelectric conversion element was manufactured in the same manner as in working example 10 in all other respects.

### <Working Example 23>

An electrolytic solution was prepared by using a mixture solvent of EMImFAP and triglyme mixed at a 1:1 weight ratio as a solvent. A dye sensitized photoelectric conversion element was manufactured in the same manner as in working example 10 in all other respects.

### <Comparative Example 24>

An electrolytic solution was prepared by using diglyme as a solvent. A dye sensitized photoelectric conversion element was manufactured in the same manner as in working example 10 in all other respects.

### <Comparative Example 25>

An electrolytic solution was prepared by using EMImTCB as a solvent. A dye sensitized photoelectric conversion element was manufactured in the same manner as in working example 10 in all other respects.

### <Comparative Example 26>

An electrolytic solution was prepared by using MPN as a solvent. A dye sensitized photoelectric conversion element was manufactured in the same manner as in working example 10 in all other respects.

### <Comparative Example 27>

An electrolytic solution was prepared by using a mixture solvent of EMImTCB and PhAN (phenylacetonitrile) mixed at a 1:1 weight ratio as a solvent. A dye sensitized photoelectric conversion element was manufactured in the same manner as in working example 10 in all other respects.

### <Comparative Example 28>

An electrolytic solution was prepared by using a mixture solvent of EMImBF₄ (1-ethyl-3-methylimidazolium tetrafluoroborate) and triglyme mixed at a 1:1 weight ratio as a solvent. A dye sensitized photoelectric conversion element was manufactured in the same manner as in working example 10 in all other respects.

### <Comparative Example 29>

An electrolytic solution was prepared by using a mixture solvent of EMImOTf (1-ethyl-3-methylimidazolium trifluorometanesulfonate) and triglyme mixed at a 1:1 weight ratio as a solvent. A dye sensitized photoelectric conversion element was manufactured in the same manner as in working example 10 in all other respects.

### <Comparative Example 30>

An electrolytic solution was prepared by using a mixture solvent of P₂₂₂MOMTFSI (triethyl(methoxymethyl)phosphonium bis (trifluoromethylsufonyl) imide)) and triglyme mixed at a 1:1 weight ratio as a solvent. A dye sensitized photoelectric conversion element was manufactured in the same manner as in working example 10 in all other respects.

### <Comparative Example 31>

An electrolytic solution was prepared by using a mixture solvent of EMImBF₄ and triglyme mixed at a 1:1 weight ratio as a solvent. A dye sensitized photoelectric conversion element was manufactured in the same manner as in working example 10 in all other respects.

Table 4 illustrates the results of finding the decrease in evaporation rate Zᵥₐₚₒᵣ of each of the mixture solvents of an ionic liquid and organic solvent in working examples 10 to 23 and comparative examples 27 to 30. It should be noted, however, that the weight percent of the organic solvent in each of the mixture solvents is 50wt%. Zᵥₐₚₒᵣ is defined as Zᵥₐₚₒᵣ = [1-(weight percent of organic solvent in mixture solvent) × (kₘᵢₓₜᵤᵣₑ/ₖₙₑₐₜ) × 100. kₙₑₐₜ is the evaporation rate of the organic solvent alone. kₘᵢₓₜᵤᵣₑ is the evaporation rate of the mixture solvent of the ionic liquid and organic solvent. Both of them are found by TG (Thermo Gravimetry) - DTA (Differential Thermal Analysis) measurement. The larger Zᵥₐₚₒᵣ, the lower the volatility of the organic solvent component in the mixture solvent than that the organic solvent used alone.

**(Table 4)**

| | Ionic Liquid | Organic Solvent | Zᵥₐₚₒᵣ |
|---|---|---|---|
| Working Example 10 | EMImTCB | diglyme | 50 |
| Working Example 11 | EMIMTCB | triglyme | 59 |
| Working Example 12 | EMImTCB | tetraglyme | 78 |
| Working Example 13 | EMImTCB | MPN | 12 |
| Working Example 14 | EMImTCB | PhOAN | 11 |
| Working Example 15 | EMImTCB | GBL | 14 |
| Working Example 16 | EMImTCB | PC | 9 |
| Working Example 17 | EMImTCB | aniline | 31 |
| Working Example 18 | EMImTCB | DMF | 39 |
| Working Example 19 | EMImTCB | DManiline | 8 |
| Working Example 20 | EMImTCB | NBB | 6 |
| Working Example 21 | EMImTCB | TBP | 7 |
| Working Example 22 | EMImTFSI | triglyme | 37 |
| Working Example 23 | EMImFAP | triglyme | 25 |
| Comparative Example 27 | EMImTCB | PhAN | 0 |
| Comparative Example 28 | EMImBF₄ | triglyme | -12 |
| Comparative Example 29 | EMImOTf | triglyme | -2 |
| Comparative Example 30 | P₂₂₂MOMTFSI | triglyme | -9 |

From Table 4, Zᵥₐₚₒᵣ is large and positive in working examples 10 to 31, showing that the volatility of the organic solvent component has declined as a result of the mixture of the ionic liquid and organic solvent. In contrast, Zᵥₐₚₒᵣ is zero or negative in comparative examples 27 to 30, showing that the volatility of the organic solvent component has not declined as a result of the mixture of the ionic liquid and organic solvent.

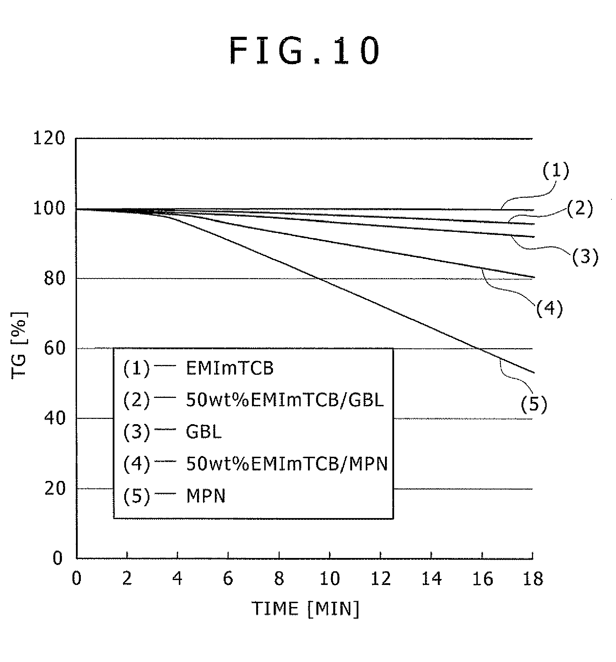

Fig. 10 illustrates TG-DTA curves of various solvents. As is clear from Fig. 10, the decrease in weight is significantly smaller when a mixture solvent of EMImTCB and MPN (weight percent of EMImTCB is 50wt%) is used (working example 13, curve (4)) than when MPN is used alone (curve (5)). On the other hand, the decrease in weight is smaller when a mixture solvent of EMImTCB and GBL (weight percent of EMImTCB is 50wt%) is used (working example 15, curve (2)) than when GBL is used alone (curve (3)).

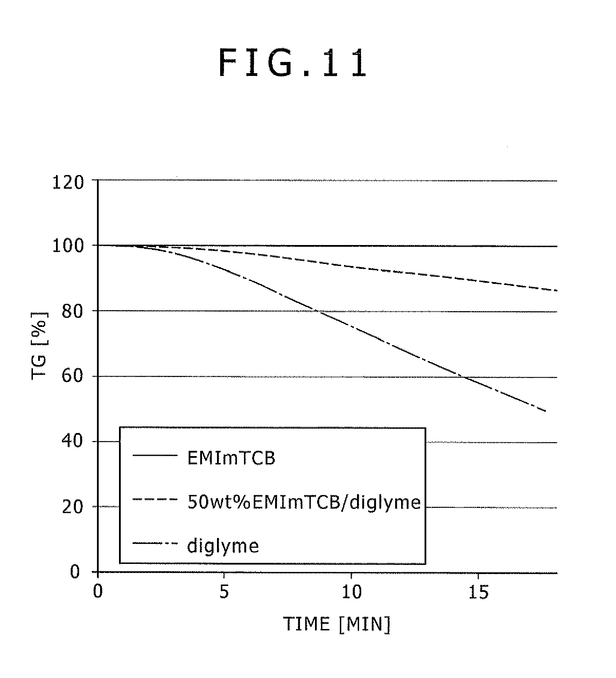

Fig. 11 illustrates TG-DTA curves obtained when a mixture solvent of EMImTCB and diglyme (weight percent of EMImTCB is 50wt%) is used, when EMImTCB is used alone and when diglyme is used alone. It is clear from Fig. 11 that, when a mixture solvent of EMImTCB and diglyme is used, the decrease in weight is significantly smaller than when diglyme is used alone and is kept close to that when EMImTCB is used alone.

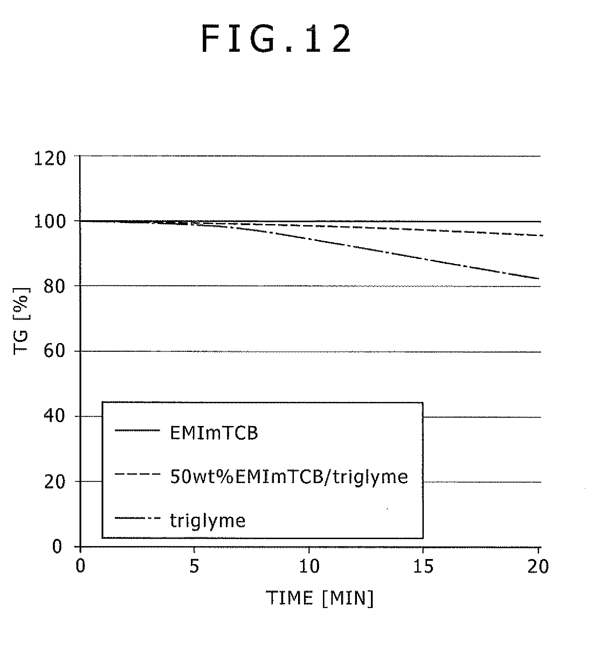

Fig. 12 illustrates TG-DTA curves obtained when a mixture solvent of EMImTCB and triglyme (weight percent of EMImTCB is 50wt%) is used (working example 11), when EMImTCB is used alone and when triglyme is used alone. It is clear from Fig. 12 that, when a mixture solvent of EMImTCB and triglyme is used, the decrease in weight is significantly smaller than when triglyme is used alone and is kept close to that when EMImTCB is used alone.

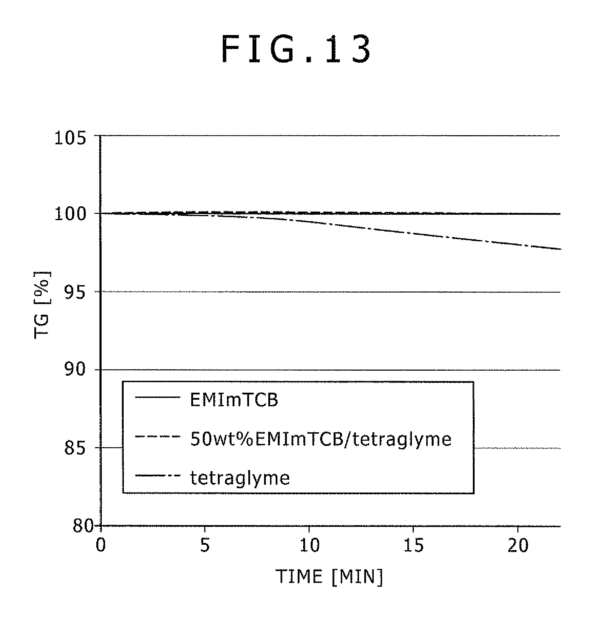

Fig. 13 illustrates TG-DTA curves obtained when a mixture solvent of EMImTCB and tetraglyme (weight percent of EMImTCB is 50wt%) is used (working example 12), when EMImTCB is used alone and when tetraglyme is used alone. It is clear from Fig. 13 that, when a mixture solvent of EMImTCB and tetraglyme is used, the decrease in weight is significantly smaller than when tetraglyme is used alone, and that the weight remains almost unchanged from when EMImTCB is used alone.

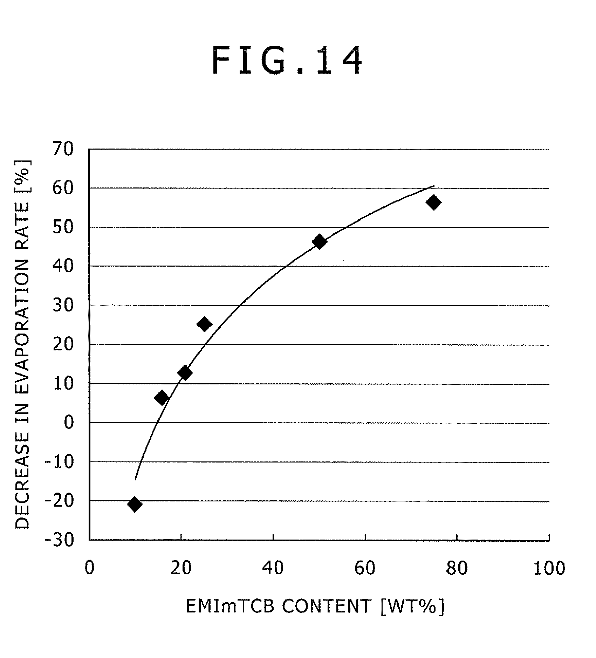

Fig. 14 is a schematic diagram illustrating results of investigation on the relationship between the content of EMImTCB in a mixture solvent of EMImTCB and diglyme and the percentage of decrease in evaporation rate. Fig. 14 shows that when the content of EMImTCB is 15 weight percent or more, the evaporation rate decreases.

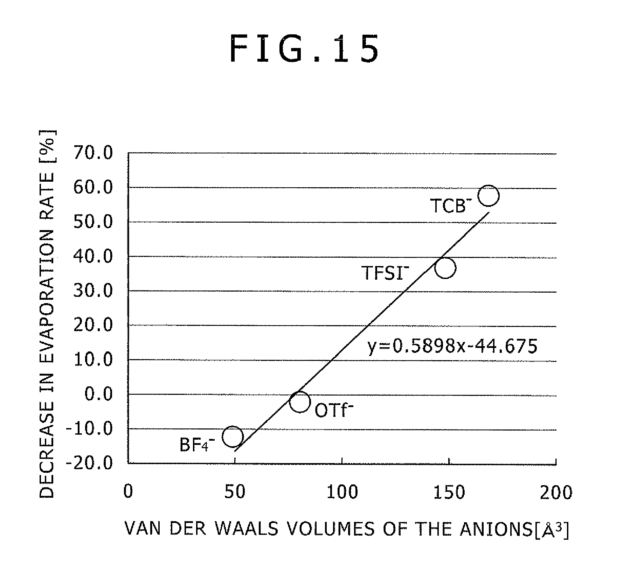

A description will be given next of suitable cation and anion structures of the ionic liquid. First, as for the cation, an organic cation is suitable which includes an aromatic amine cation having quaternary nitrogen atoms and which has hydrogen atoms in the aromatic ring. Among examples of such an organic cation are imidazolium cation, pyridium cation, thiazolium cation and pyrazolium cation. On the other hand, the anion can be defined by the van der Waals volume (electron cloud size) of the anion calculated based on computational science. Fig. 15 is a diagram plotting the percentages of decrease in evaporation rate of several anions (TCB⁻, TFSI⁻, OTf⁻ and BF₄⁻) relative to their van der Waals volumes. The Journal of The Electrochemical Society 002, 149(10), A1385-A1388(2002) was referenced for the van der Waals volume of each of the anions. As the van der Waals volume of the TCB anion, that of the (C₂H₅)₄B⁻ anion having a structure similar to that of the TCB anion was used. These pieces of data were fitted by a linear function. Letting the van der Waals volume be denoted by `x' and the percentage of decrease in evaporation rate denoted by 'y,' the fitting formula is y = 0.5898x - 44.675. It is likely from Fig. 15 that the anions with a van der Waals volume of 100 Å³ or more will suitably undergo a decrease in evaporation rate.

A description will be given next of results of examination of the principle behind the decrease in evaporation rate of a mixture solvent made up of an ionic liquid having electron pair accepting functional groups and an organic solvent having electron pair donating functional groups.

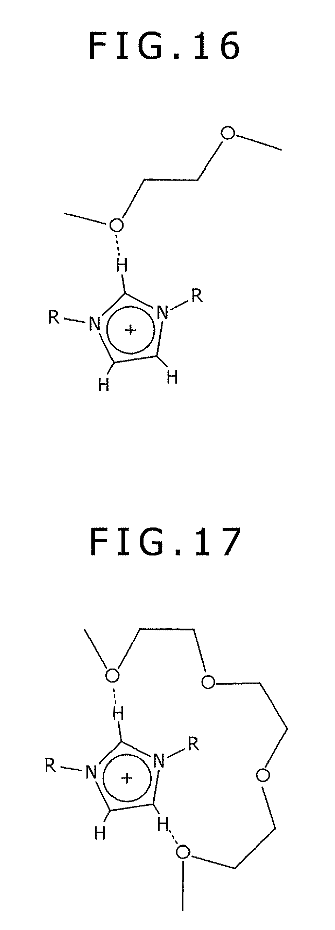

In this mixture solvent, hydrogen bonds are formed between the electron pair accepting functional groups of the ionic liquid and the electron pair donating functional groups (ether group or amino group) of the organic solvent, thus making the solvent thermally stable. Fig. 16 illustrates an example thereof. As illustrated in Fig. 16, a hydrogen bond (shown by a dashed line) is formed between the electron pair accepting functional group (acidic proton) of the imidazolium cation in the ionic liquid and the ether group (-O-) of the diglyme molecule. As described above, it is possible to think that the evaporation rate of this mixture solvent decreases because the solvent becomes thermally stable as a result of the formation of hydrogen bonds between the ionic liquid and organic solvent.

In particular, the more there are electron pair donating functional groups in each molecule of the organic solvent, the larger the percentage of decrease in evaporation rate. For example, Fig. 17 illustrates an example in which the organic solvent is triglyme. In this example, a hydrogen bond is formed between each of the two electron pair accepting functional groups (acidic protons) of the imidazolium cation of the ionic liquid and each of the two ether groups of triglyme, thus making the mixture solvent thermally stable. Further, in this case, when a hydrogen bond is formed between one of the electron pair accepting functional groups of the imidazolium cation of the ionic liquid and one of the ether groups of triglyme, the other ether group of triglyme comes close to the other electron pair accepting functional group of the imidazolium cation of the ionic liquid. In other words, triglyme involves the imidazolium cation. This makes it easier for the other electron pair accepting functional group of the imidazolium cation of the ionic liquid to react with the other ether group of triglyme, thus forming a hydrogen bond therebetween.

The second embodiment provides the following advantage in addition to the same advantage as offered by the first embodiment. That is, in the second embodiment, a mixture solvent made up of an ionic liquid having electron pair accepting functional groups and an organic solvent having electron pair donating functional groups is used as a solvent of the electrolytic solution forming the electrolyte layer 7, thus effectively suppressing the evaporation of the electrolytic solution. Moreover, this mixture solvent is low in viscosity coefficient, thus making it possible to reduce the viscosity coefficient of the electrolytic solution and therefore providing a dye sensitized photoelectric conversion element offering excellent photoelectric conversion characteristic.

### <3. Third Embodiment>

### [Dye Sensitized Photoelectric Conversion Element]

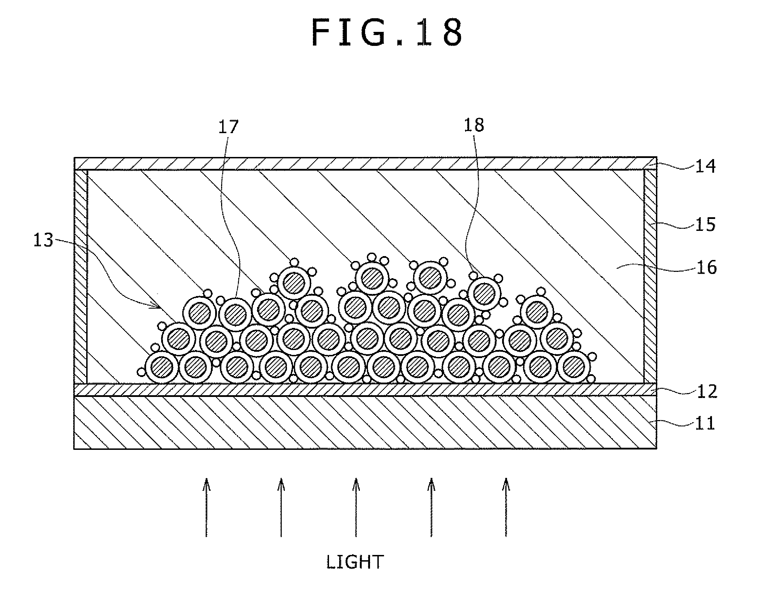

Fig. 18 is a sectional view illustrating a dye sensitized photoelectric conversion element according to a third embodiment.

As illustrated in Fig. 18, a transparent electrode 12 is provided on one of the main surfaces of a transparent substrate 11 in this dye sensitized photoelectric conversion element. A porous photoelectrode 13 is provided on the transparent electrode 12 to which one or a plurality of types of photosensitizing dyes are bound (or adsorbed). On the other hand, a counter electrode 14 is provided in such a manner as to be opposed to the transparent substrate 11. Then, the outer peripheries of the transparent substrate 11 and counter electrode 14 are sealed with a sealing agent 15. An electrolyte layer 16 made of an electrolytic solution is filled between the porous photoelectrode 13 provided above the transparent substrate 11 and the counter electrode 14.

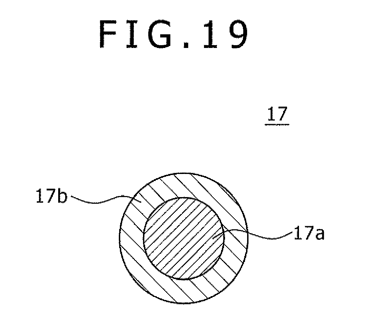

The porous photoelectrode 13 includes metal/metal oxide fine particles 17 and is typically made of a material obtained by sintering the metal/metal oxide fine particles 17. The structure of the metal/metal oxide fine particle 17 is shown in detail in Fig. 19. As illustrated in Fig. 19, the metal/metal oxide fine particle 17 has a core-shell structure that includes a spherical metallic core 17a and a metal oxide shell 17b that wraps around the core 17a. One or a plurality of types of photosensitizing dyes are bound (or adsorbed) to the surface of the metal oxide shell 17b of the metal/metal oxide fine particle 17.

A metal oxide such as titanium oxide (TiO₂) , tin oxide (SnO₂), niobium oxide (Nb₂O₅) or zinc oxide (ZnO) is, for example, used to form the shell 17b of the metal/metal oxide fine particle 17. Of these metal oxides, TiO₂ and above all, TiO₂ in an anatase form, should preferably be used. It should be noted, however, that the types of semiconductors that can be used are not limited thereto, and that two or more different semiconductors can be mixed or conjugated for use as necessary. Further, the metal/metal oxide fine particles 17 may be in any form including a particle, tubular or bar form.

Although the size of the metal/metal oxide fine particles 17 is not specifically limited, the average size of primary particles is generally 1 to 500 nm. Further, it is, above all, preferred that the average size should be 1 to 200 nm, and particularly preferred that the average size should be 5 to 100 nm. On the other hand, the size of the core 17a of the metal/metal oxide fine particles 17 is generally 1 to 200 nm.

The same materials as used for the transparent substrate 1, transparent electrode 2, counter electrode 6 and electrolyte layer 7 of the dye sensitized photoelectric conversion element according to the first embodiment can be used for the transparent substrate 11, transparent electrode 12, counter electrode 14 and electrolyte layer 16.

### [Manufacturing Method of the Dye Sensitized Photoelectric Conversion Element]

A description will be given next of the manufacturing method of this dye sensitized photoelectric conversion element.

First, the transparent electrode 12 is formed on one of the main surfaces of the transparent substrate 11, for example, by sputtering.

Next, the porous photoelectrode 13 including the metal/metal oxide fine particles 17 is formed on the transparent electrode 12.

After coating or printing the transparent electrode 12 with the metal/metal oxide fine particles 17, the porous photoelectrode 13 should preferably be fired to achieve electrical connection between the metal/metal oxide fine particles 17 and provide improved mechanical strength of the porous photoelectrode 13 and improved adhesion thereof to the transparent electrode 12.

Next, a photosensitizing dye 18 is adsorbed to the porous photoelectrode 13 by immersing the transparent substrate 11 having the porous photoelectrode 13 formed thereon in a solution in which the photosensitizing dye 18 is dissolved in a given solvent.

On the other hand, the counter electrode 14 is formed on the opposed substrate, for example, by sputtering.

Next, the transparent substrate 11 having the porous photoelectrode 13 formed thereabove and the counter electrode 14 are arranged in such a manner that the porous photoelectrode 13 and counter electrode 14 are opposed to each other with a given spacing of 1 to 100 µm, and preferably 1 to 50 µm, therebetween. Then, the sealing agent 15 is formed on the outer peripheries of the transparent substrate 11 and counter electrode 14 to produce a space in which the electrolyte layer is to be sealed. The electrolyte layer 16 is, for example, filled into this space via the filling port (not shown) formed in advance in the transparent electrode 11, after which the filling port is closed.

The manufacturing method is identical to that according to the first embodiment in all other respects.

The intended dye sensitized photoelectric conversion element is manufactured as described above.

The metal/metal oxide fine particles 17 forming the porous photoelectrode 13 can be manufactured by a conventional well-known method (refer, for example, to Jpn. J. Appl. Phys. Vol. 46, No. 4B, 2007, pp. 2567 - 2570). As an example, the outline of the manufacturing method of the metal/metal oxide fine particles 17 whose core 17a is made of Au and whose shell 17b is made of TiO₂ is as follows. That is, dehydrated trisodium citrate is mixed into a heated 500 mL solution of 5 × 10⁻⁴MHAuCl₄ and agitated. Next, a 2.5wt% of mercaptoundecanoic acid is added to an aqueous ammonium solution and agitated, and then the solution is added to an Au nanoparticle dispersion solution, after which the temperature of the mixture is maintained constant for two hours. Next, 1 M of HCl is added to adjust the pH of the solution to 3. Next, titanium isopropoxide and triethanol amine are added to the Au colloid solution under a nitrogen atmosphere. The metal/metal oxide fine particles 17 each of whose cores 17a is made of Au and each of whose shells 17b is made of TiO₂ is manufactured as described above.

### [Operation of the Dye Sensitized Photoelectric Conversion Element]

A description will be given next of the operation of the dye sensitized photoelectric conversion element.

This dye sensitized photoelectric conversion element operates as a battery having the counter electrode 14 as a cathode and the transparent electrode 12 as an anode when struck with light. The operating principle is as described below. It should be noted that we assume here that FTO is used as the material of the transparent electrode 12, Au as the material of the core 17a and TiO₂ as the material of the shell 17b of the metal/metal oxide fine particles 17 forming the porous photoelectrode 13, and that redox species I⁻/I₃⁻ is used as a redox couple. However, the materials of the transparent electrode 12 and porous photoelectrode 13 and the redox couple are not limited thereto.

When the photosensitizing dye 18, bound to the porous photoelectrode 13, absorbs the photons that strike the porous photoelectrode 13 after having passed through the transparent substrate 11 and transparent electrode 12, the electrons in the photosensitizing dye 18 are excited from a ground state (HOMO) to an excited state (LUMO). The electrons thus excited are drawn out into the conduction band of TiO₂ forming the shell 17b of the metal/metal oxide fine particles 17 forming the porous photoelectrode 13 via the electrical coupling between the photosensitizing dye 18 and porous photoelectrode 13, thus passing through the porous photoelectrode 13 and reaching the transparent electrode 12. In addition, when light strikes the surface of the Au-made core 17a of each of the metal/metal oxide fine particles 17, localized surface plasmons are excited, thus providing field enhancement effect. Then, a large number of electrons are excited by this enhanced electric field into the conduction band of TiO₂ forming the shell 17b, thus passing through the porous photoelectrode 13 and reaching the transparent electrode 12. As described above, when the porous photoelectrode 13 is struck with light, the electrons generated by the excitation of the photosensitizing dye 18 reach the transparent electrode 12. In addition, the electrons excited into the conduction band of the TiO₂ forming the shell 17b as a result of the excitation of localized surface plasmons on the surface of the core 17a of each of the metal/metal oxide fine particles 17 also reach the transparent electrode 12. This contributes to high photoelectric conversion efficiency.

On the other hand, the photosensitizing dye 18 that has lost its electrons receives electrons from the reductant such as I⁻ in the electrolyte layer 16, for example, as a result of the reaction shown below, thus producing an oxidant such as I₃⁻ (conjugate between I₂ and I⁻) in the electrolyte layer 16.

2I⁻ → I₂ + 2e⁻

I₂ + I⁻ → I₃⁻

The oxidant thus produced reaches the counter electrode 14 as a result of dispersion and receives electrons from the counter electrode 14 by the reverse reaction of the above reaction, thus being reduced back to the original reductant.

I3⁻ → I₂ + I⁻

I₂ + 2e⁻ → 2I⁻

The electrons sent out from the transparent electrode 12 to external circuitry perform electrical work in the external circuitry and then return to the counter electrode 14. As described above, optical energy is converted into electrical energy without making any change to the photosensitizing dye 18 or electrolyte layer 16.

The third embodiment provides the following advantage in addition to the same advantage as offered by the first embodiment. That is, the porous photoelectrode 13 includes the metal/metal oxide fine particles 17 having a core-shell structure made up of the spherical metallic core 17a and the metal oxide shell 17b that wraps around the core 17a. This keeps the electrolyte of the electrolyte layer out of contact with the core 17a made of the metal of the metal/metal oxide fine particles 17 when the electrolyte of the electrolyte layer 16 is filled between this porous photoelectrode 13 and counter electrode 14, thus preventing the dissolution of the porous photoelectrode 13 by the electrolyte. This makes it possible to use, for example, gold, silver and copper having large surface plasmon resonance effect as a metal forming the core 17a of each of the metal/metal oxide fine particles 17, thus achieving sufficient surface plasmon resonance effect. Further, an iodine-based electrolyte can be used as the electrolyte of the electrolyte layer 16. This provides a photoelectric conversion element offering high photoelectric conversion characteristic. High performance electronic equipment can be achieved by using this excellent photoelectric conversion element.

### <4. Fourth Embodiment>

### [Photoelectric Conversion Element]

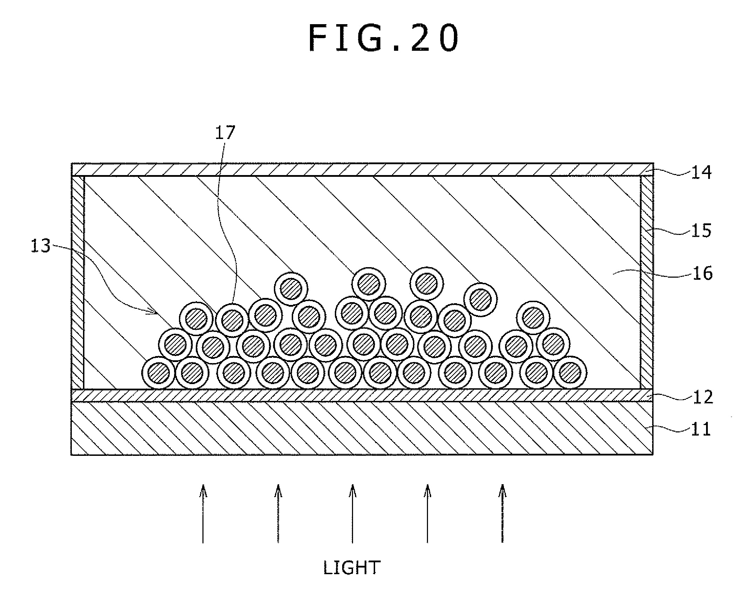

As shown in FIG. 20, the photoelectric conversion element according to a fourth embodiment has the same configuration as the dye sensitized photoelectric conversion element according to the third embodiment except that the photosensitizing dye 18 is not bound to the metal/metal oxide fine particles 17 forming the porous photoelectrode 13.

### [Manufacturing Method of the Photoelectric Conversion Element]

The manufacturing method of this photoelectric conversion element is identical to that of the dye sensitized photoelectric conversion element according to the third embodiment except that the photosensitizing dye 18 is not adsorbed to the porous photoelectrode 13.

### [Operation of the Photoelectric Conversion Element]

A description will be given next of the operation of this photoelectric conversion element.

This photoelectric conversion element operates as a battery having the counter electrode 14 as a cathode and the transparent electrode 12 as an anode when struck with light. The operating principle is as described below. It should be noted that we assume here that FTO is used as the material of the transparent electrode 12, Au as the material of the core 17a and TiO₂ as the material of the shell 17b of each of the metal/metal oxide fine particles 17 forming the porous photoelectrode 13, and that redox species I⁻/I₃⁻ is used as a redox couple. However, the materials of the transparent electrode 12 and porous photoelectrode 13 and the redox couple are not limited thereto.

When light strikes the surface of the Au-made core 17a of each of the metal/metal oxide fine particles 17 forming the porous photoelectrode 13 after having passed through the transparent substrate 11 and transparent electrode 12, localized surface plasmons are excited, thus providing field enhancement effect. Then, a large number of electrons are excited by this enhanced electric field into the conduction band of TiO₂ forming the shell 17b, thus passing through the porous photoelectrode 13 and reaching the transparent electrode 12.

On the other hand, the porous photoelectrode 13 that has lost its electrons receives electrons from the reductant such as I⁻ in the electrolyte layer 16, for example, as a result of the reaction shown below, thus producing an oxidant such as I₃⁻ (conjugate between I₂ and I⁻) in the electrolyte layer 16.

2I⁻ → I₂ + 2e⁻

I₂ + I⁻ → I₃⁻

The oxidant thus produced reaches the counter electrode 14 as a result of dispersion and receives electrons from the counter electrode 14 by the reverse reaction of the above reaction, thus being reduced back to the original reductant.

I₃⁻ → I₂ + I⁻

I₂ + 2e⁻ → 2I⁻

The electrons sent out from the transparent electrode 12 to external circuitry perform electrical work in the external circuitry and then return to the counter electrode 14. As described above, optical energy is converted into electrical energy without making any change to the photosensitizing dye 18 or electrolyte layer 16.

The fourth embodiment provides the same advantages as offered by the second embodiment.

### <5. Fifth Embodiment>

### [Photoelectric Conversion Element]

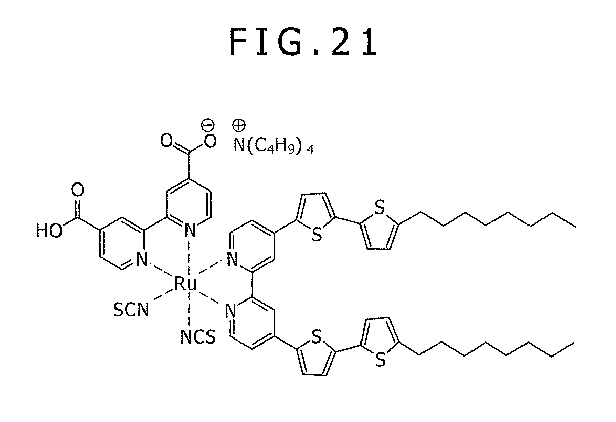

In this dye sensitized photoelectric conversion element, Z991 is used as the photosensitizing dye 18 adsorbed to the porous photoelectrode 3. This dye sensitized photoelectric conversion element is identical to the counterpart according to the first embodiment in all other respects. Fig. 21 illustrates the structural formula of the Z991.

### [Manufacturing Method of the Photoelectric Conversion Element]

The manufacturing method of this dye sensitized photoelectric conversion element is identical to that of the dye sensitized photoelectric conversion element according to the first embodiment except that the Z991 is used as the photosensitizing dye 18 adsorbed to the porous photoelectrode 3.

### <Working Example 24>

An electrolytic solution was prepared by using 4-MeO-Py as an additive. A dye sensitized photoelectric conversion element was manufactured in the same manner as in working example 1 in all other respects.

### <Working Example 25>

An electrolytic solution was prepared by using 25-Lu as an additive. A dye sensitized photoelectric conversion element was manufactured in the same manner as in working example 1 in all other respects.

### <Working Example 26>

An electrolytic solution was prepared by using 26-Lu as an additive. A dye sensitized photoelectric conversion element was manufactured in the same manner as in working example 1 in all other respects.

### <Comparative Example 32>

An electrolytic solution was prepared by using TBP as an additive. A dye sensitized photoelectric conversion element was manufactured in the same manner as in working example 1 in all other respects.

Table 5 illustrates the pKₐ (water), photoelectric conversion efficiencies (Eff.) and internal resistances (Rs) in working examples 24 to 26 and comparative example 32. It is clear from Table 5 that each of working examples 24 to 26, all using an additive having a pKₐ falling within the range of 6.04 ≤ pKₐ ≤ 7.3, offers a higher photoelectric conversion efficiency (Eff.) and a lower internal resistance (Rs) than comparative example 32 using 4-tert-butylpyridine.

**(Table 5)**

| | Additive | pKₐ (water) | Eff[%] | Rₛ[ Ω] |
|---|---|---|---|---|
| Working Example 24 | 4-MeO-Py | 6.62 | 9.2 | 26.1 |
| Working Example 25 | 25-Lu | 6.47 | 9.2 | 27.1 |
| Working Example 26 | 26-Lu | 6.77 | 9.4 | 24.8 |
| Comparative Example 32 | TBP | 5.99 | 8.6 | 34.2 |

The fifth embodiment provides the same advantages as offered by the first embodiment.

Although the embodiments and working examples of the present invention have been described above, the present invention is not limited to the above embodiments and working examples. Instead, the present invention may be modified in various ways based on technical ideas.

For example, the numerical values, structures, configurations, shapes, materials and so on cited in the above embodiments and working examples are merely examples, and numerical values, structures, configurations, shapes, materials and so on different therefrom may be used as necessary.

### Description of Reference Numerals

1...Transparent substrate, 2...Transparent electrode, 3...Porous photoelectrode, 4...Opposed substrate, 5...Transparent conductive layer, 6...Counter electrode, 7...Electrolyte layer, 11...Transparent substrate, 12...Transparent electrode, 13...Porous photoelectrode, 14...Counter electrode, 15...Sealing agent, 16...Electrolyte layer, 17...Metal/metal oxide fine particles, 17a...Core, 17b...Shell, 18...Photosensitizing dye

## Claims

1. A photoelectric conversion element having a structure in which an electrolyte layer is filled between a porous photoelectrode and counter electrode, wherein
an additive having a pKₐ falling within the range of 6.04 ≤ pKₐ ≤ 7.3 is added to the electrolyte layer, and/or wherein
the additive having a pKₐ falling within the range of 6.04 ≤ pKₐ ≤ 7.3 is adsorbed to the surface of at least either the porous photoelectrode or counter electrode facing the electrolyte layer.

2. The photoelectric conversion element of claim 1,
wherein
the additive is a pyridine-based additive or an additive having a heterocycle.

3. The photoelectric conversion element of claim 2,
wherein
the additive comprises at least one selected from among a group made up of 2-aminopyridine, 4-methoxypyridine, 4-ethylpyridine, N-methylimidazole, 2,4-lutidine, 2,5-lutidine, 2,6-lutidine, 3,4-lutidine and 3,5-lutidine.

4. The photoelectric conversion element of claim 1,
wherein
the electrolyte layer comprises an electrolytic solution, and wherein
the molecular weight of the solvent of the electrolytic solution is 47.36 or more.

5. The photoelectric conversion element of claim 4,
wherein
the solvent is 3-methoxypropionitrile, methoxyacetonitrile or a mixture of acetonitrile and valeronitrile.

6. The photoelectric conversion element of claim 1 being:
a dye sensitized photoelectric conversion element in which a photosensitizing dye is bound to the porous photoelectrode.

7. The photoelectric conversion element of claim 6,
wherein
the dye is a polypyridine complex having a saturated hydrocarbon group whose carbon number is 6 or more.

8. The photoelectric conversion element of claim 1,
wherein
the porous photoelectrode comprises fine particles made of a semiconductor.

9. The photoelectric conversion element of claim 1,
wherein
the electrolyte layer comprises an electrolytic solution, and wherein
the solvent of the electrolytic solution includes an ionic liquid having electron pair accepting functional groups and an organic solvent having electron pair donating functional groups.

10. The photoelectric conversion element of claim 1, wherein
the porous photoelectrode comprises fine particles, each having a metallic core and a metal oxide shell wrapped around the core.

11. A manufacturing method of a photoelectric conversion element comprising a step of:
adding an additive having a pKₐ falling within the range of 6.04 ≤ pKₐ ≤ 7.3 to an electrolyte layer filled between a porous photoelectrode and counter electrode; and/or a step of:
causing the additive having a pKₐ falling within the range of 6.04 ≤ pKₐ ≤ 7.3 to be adsorbed to the surface of at least either the porous photoelectrode or counter electrode facing the electrolyte layer.

12. The manufacturing method of a photoelectric conversion element of claim 11, wherein
the additive is a pyridine-based additive or an additive having a heterocycle.

13. The manufacturing method of a photoelectric conversion element of claim 12, wherein
the additive comprises at least one selected from among a group made up of 2-aminopyridine, 4-methoxypyridine, 4-ethylpyridine, N-methylimidazole, 2,4-lutidine, 2,5-lutidine, 2,6-lutidine, 3,4-lutidine and 3,5-lutidine.

14. The manufacturing method of a photoelectric conversion element of claim 11, wherein
when a structure is formed in which the electrolyte layer made of an electrolytic solution is filled between the porous photoelectrode and counter electrode, a solvent having a molecular weight of 47.36 or more is contained in the electrolytic solution.

15. The manufacturing method of a photoelectric conversion element of claim 14, wherein
the solvent is 3-methoxypropionitrile, methoxyacetonitrile or a mixture of acetonitrile and valeronitrile.

16. The manufacturing method of a photoelectric conversion element of claim 11 further comprising
a step of binding a photosensitizing dye to the porous photoelectrode.

17. The manufacturing method of a photoelectric conversion element of claim 11, wherein
the porous photoelectrode comprises
fine particles made of a semiconductor.

18. The manufacturing method of a photoelectric conversion element of claim 11, wherein
when a structure is formed in which the electrolyte layer made of an electrolytic solution is filled between the porous photoelectrode and counter electrode, an ionic liquid having electron pair accepting functional groups and an organic solvent having electron pair donating functional groups are contained in the electrolytic solution.

19. The manufacturing method of a photoelectric conversion element of claim 11, wherein
the porous photoelectrode comprises fine particles, each having a metallic core and a metal oxide shell wrapped around the core.

20. Electronic equipment comprising at least:
a photoelectric conversion element, the photoelectric conversion element having a structure in which an electrolyte layer is filled between a porous photoelectrode and counter electrode, wherein
an additive having a pKₐ falling within the range of 6.04 ≤ pKₐ ≤ 7.3 is added to the electrolyte layer, and/or wherein
the additive having a pKₐ falling within the range of 6.04 ≤ pKₐ ≤ 7.3 is adsorbed to the surface of at least either the porous photoelectrode or counter electrode facing the electrolyte layer.

## Amended claims

### Amended claims under Art. 19.1 PCT

1. A photoelectric conversion element having a structure in which an electrolyte layer is filled between a porous photoelectrode and counter electrode, wherein
an additive having a pKₐ falling within the range of 6.04 ≤ pKₐ ≤ 7.3 is added to the electrolyte layer, and/or wherein
the additive having a pKₐ falling within the range of 6.04 ≤ pKₐ ≤ 7.3 is adsorbed to the surface of at least either the porous photoelectrode or counter electrode facing the electrolyte layer.

2. The photoelectric conversion element of claim 1,
wherein
the additive is a pyridine-based additive or an additive having a heterocycle.

3. The photoelectric conversion element of claim 2,
wherein
the additive comprises at least one selected from among a group made up of 2-aminopyridine, 4-methoxypyridine, 4-ethylpyridine, N-methylimidazole, 2,4-lutidine, 2,5-lutidine, 2,6-lutidine, 3,4-lutidine and 3,5-lutidine.

4. The photoelectric conversion element of claim 1,
wherein
the electrolyte layer comprises an electrolytic solution, and wherein
the molecular weight of the solvent of the electrolytic solution is 47.36 or more.

5. The photoelectric conversion element of claim 4,
wherein
the solvent is 3-methoxypropionitrile, methoxyacetonitrile or a mixture of acetonitrile and valeronitrile.

6. The photoelectric conversion element of claim 1 being:
a dye sensitized photoelectric conversion element in which a photosensitizing dye is bound to the porous photoelectrode.

7. (Amended) The photoelectric conversion element of claim 6, wherein
the dye is a polypyridine complex having a saturated hydrocarbon group whose carbon number is 6 or more.

8. (Amended) The photoelectric conversion element of claim 1, wherein
the porous photoelectrode comprises fine particles made of a semiconductor.

9. (Amended) The photoelectric conversion element of claim 1, wherein
the electrolyte layer comprises an electrolytic solution, and wherein
the solvent of the electrolytic solution includes an ionic liquid having electron pair accepting functional groups and an organic solvent having electron pair donating functional groups.

10. (Amended) The photoelectric conversion element of claim 1, wherein
the porous photoelectrode comprises fine particles, each having a metallic core and a metal oxide shell wrapped around the core.

11. (Amended) A manufacturing method of a photoelectric conversion element comprising a step of:
adding an additive having a pKₐ falling within the range of 6.04 ≤ pKₐ ≤ 7.3 to an electrolyte layer filled between a porous photoelectrode and counter electrode; and/or a step of:
causing the additive having a pKₐ falling within the range of 6.04 ≤ pKa ≤ 7.3 to be adsorbed to the surface of at least either the porous photoelectrode or counter electrode facing the electrolyte layer.

12. (Amended) The manufacturing method of a photoelectric conversion element of claim 11, wherein
the additive is a pyridine-based additive or an additive having a heterocycle.

13. (Amended) The manufacturing method of a photoelectric conversion element of claim 12, wherein
the additive comprises at least one selected from among a group made up of 2-aminopyridine, 4-methoxypyridine, 4-ethylpyridine, N-methylimidazole, 2,4-lutidine, 2,5-lutidine, 2,6-lutidine, 3,4-lutidine and 3,5-lutidine.

14. (Amended) The manufacturing method of a photoelectric conversion element of claim 11, wherein
when a structure is formed in which the electrolyte layer made of an electrolytic solution is filled between the porous photoelectrode and counter electrode, a solvent having a molecular weight of 47.36 or more is contained in the electrolytic solution.

15. (Amended) The manufacturing method of a photoelectric conversion element of claim 14, wherein
the solvent is 3-methoxypropionitrile, methoxyacetonitrile or a mixture of acetonitrile and valeronitrile.

16. (Amended) The manufacturing method of a photoelectric conversion element of claim 11 further comprising
a step of binding a photosensitizing dye to the porous photoelectrode.

17. (Amended) The manufacturing method of a photoelectric conversion element of claim 11, wherein
the porous photoelectrode comprises
fine particles made of a semiconductor.

18. (Amended) The manufacturing method of a photoelectric conversion element of claim 11, wherein
when a structure is formed in which the electrolyte layer made of an electrolytic solution is filled between the porous photoelectrode and counter electrode, an ionic liquid having electron pair accepting functional groups and an organic solvent having electron pair donating functional groups are contained in the electrolytic solution.

19. (Amended) The manufacturing method of a photoelectric conversion element of claim 11, wherein
the porous photoelectrode comprises fine particles, each having a metallic core and a metal oxide shell wrapped around the core.

20. (New) Electronic equipment comprising at least:
a photoelectric conversion element, the photoelectric conversion element having a structure in which an electrolyte layer is filled between a porous photoelectrode and counter electrode, wherein
an additive having a pKₐ falling within the range of 6.04 ≤ pKₐ ≤ 7.3 is added to the electrolyte layer, and/or wherein
the additive having a pKₐ falling within the range of 6.04 ≤ pKₐ ≤ 7.3 is adsorbed to the surface of at least either the porous photoelectrode or counter electrode facing the electrolyte layer.
